# EUROPEAN PATENT SPECIFICATION

(11) **EP 2 586 074 B1**
(45) Date of publication and mention of the grant of the patent: **28.12.2016**
(21) Application number: 11727682.4
(22) Date of filing: 21.06.2011
(51) Int. Cl.: H01L 51/30

(54) **AN ORGANIC FIELD EFFECT TRANSISTOR WITH IMPROVED CURRENT ON/OFF RATIO AND CONTROLLABLE THRESHOLD SHIFT**
ORGANISCHER FELDEFFEKTTRANSISTOR MIT VERBESSERTEM ON-/OFF-STROMVERHÄLTNIS UND STEUERBARER SCHWELLENVERSCHIEBUNG
TRANSISTOR À EFFET DE CHAMP ORGANIQUE AVEC UN RAPPORT DE COURANT À L'ÉTAT PASSANT/BLOQUÉ AMÉLIORÉ ET UN DÉPLACEMENT DU SEUIL CONTRÔLABLE

(30) Priority: 24.06.2010 EP 10167194
(43) Date of publication of application: 01.05.2013
(73) Proprietor: BASF SE, 67056 Ludwigshafen am Rhein (DE)
(72) Inventor: SCHMIDHALTER, Beat, CH-4416 Bubendorf (CH); CHEBOTAREVA, Natalia, F-68220 Hagenthal le Bas (FR); HAYOZ, Pascal, CH-4114 Hofstetten (CH)
(74) Representative: BASF IP Association
(86) International application number: PCT/EP2011/060283
(87) International publication number: WO 2011/161078

(56) References cited:
- EP-A2- 2 034 537
- WO-A1-2010/049321
- WO-A2-2010/063609
- MA, L., LEE, W.H., PARK, Y.D., KIM, J.S., LEE, H.S., AND CHO, K.: "High performance polythiophne thin-film transistors doped with very small amounts of an electron acceptor", APPLIED PHYSICS LETTERS, vol. 92, 15 February 2008 (2008-02-15), pages 063310-1-063310-3, XP002611481,

## Description

The present invention provides a semiconductor device, especially an organic field effect transistor, comprising a layer comprising a polymer comprising repeating units having a diketopyrrolopyrrole skeleton (DPP polymer) and an acceptor compound having an electron affinity in vacuum of 4.6 eV, or more. The doping of the DPP polymer with the acceptor compound leads to an organic field effect transistor with improved hole mobility, current on/off ratio and controllable threshold shift.

The doping of silicon semiconductors has already been state of art for several decades. By this method, an increase in conductivity, initially quite low, is obtained by generation of charge carriers in the material as well as, depending upon the type of dopant used, a variation in the Fermi level of the semiconductor. However, several years ago it was also disclosed that organic semiconductors may likewise be strongly influenced with regard to their electrical conductivity by doping. Such organic semiconducting matrix materials may be made up either of compounds with good electron-donor properties or of compounds with good electron-acceptor properties. For doping electron-donor materials, strong electron acceptors such as tetracyanoquinonedimethane (TCNQ) or 2,3,5,6-tetrafluorotetracyano-1,4-benzoquinonedimethane (F₄TCNQ) have become well known. M. Pfeiffer, A. Beyer, T. Fritz, K. Leo, Appl. Phys. Lett., 73 (22), 3202-3204 (1998) and J. Blochwitz, M. Pfeiffer, T. Fritz, K. Leo, Appl. Phys. Lett., 73 (6), 729-731 (1998). By electron transfer processes, these produce so-called holes in electron donor-like base materials (hole-transport materials), owing to the number and mobility of which the conductivity of the base material is relatively significantly varied. For example, N,N'-perarylated benzidines TPD or N,N',N" perarylated starburst compounds, such as the substance TDATA, but also certain metal phthalocyanines, such as in particular zinc phthalocyanine ZnPc, are known as matrix materials with hole-transport properties.

EP1538684A1 (US2005121667) relates to a method which uses an organic mesomeric compound as an organic doping material for doping an organic semiconducting material to alter its electrical properties. The mesomeric compound is a quinone or a quinone derivative or a 1,3,2-dioxaborin or a 1,3,2-dioxaborin derivative and the mesomeric compound has lower volatility than the tetrafluorotrecyanoquinonedimethane under identical evaporation conditions. It is said that the dopants may be used for the production of organic light-emitting diodes (OLEDs), organic solar cells, organic diodes, or organic field-effect transistors.

Preferably, the matrix material consists partially or completely of a metal phthalocyanine complex, a porphyrin complex, an oligothiophene compound, an oligophenyl compound, an oligophenylenevinylene compound, an oligofluorene compound, a pentacene compound, a compound with a triarylamine unit and/or a spiro-bifluorene compound. WO 2009003455A1 discloses further quinoid compounds and the use thereof in semiconducting matrix materials, electronic and optoelectronic components.

US2008265216A1 relates to oxocarbon-, pseudooxocarbon- and radialene compounds as well as to their use as doping agent for doping an organic semiconductive matrix material, as blocker material, as charge injection layer, as electrode material as well as organic semiconductor, as well as electronic components and organic semiconductive materials using them.

WO2008138580A1 relates to imidazole derivatives and the use thereof as dopants for doping organic semiconductor matrix materials, organic semiconductor matrix materials, and electronic or optoelectronic components.

EP1681733 and US2010005192 discloses an organic thin film transistor compromising an acceptor layer interposed between source-drain contacts and the semiconductor layer. The method requires an additional layer, which is done over an evaporative step, which is not preferred.

E. Lim et al., J. Mater. Chem. 2007, 17,1416-1420 presents results on organic transistors using the p-type polymer semiconductor (F8T2) doped with an electron-acceptor, 2,5,6,-tetrafluore-7,7,8,8-tetracyanoquinodimethane (F₄TCNQ). Using an optimal doping ratio of 8 wt% doped F8T2 film an increased hole mobility was found, whereas the on/off ratio is in the same order for the doped (8wt%) and the undoped film.

WO200906068869 discloses chemically modified silver electrodes by using F₄TCNQ as selfassembling monolayer. This presence of the SAMs significantly shifts the transfer characteristics, which results in a rigid shift of the threshold voltage in the positive range. This requires more complex circuitry and is therefore not preferred.

W. Takashima et al., Appl. Physics Letters 91(7), 071905 and US201000065833 disclose complementary FET circuits with p-type organic and n-type materials, whereas the unipolarization is done by insertion of an acceptor layer for the p-type conducting transistor in an inverter structure.

X. Cheng et al., Adv. Funct. Material 2009, 19, 2407-2415 reports the modifaction of gold and drain electrodes by self-assembled thiol based monolayers in combination with the ambipolar polyfluorene semiconductor (F8BT). A simultaneous enhancement of electron and hole injection is found, which does not provide any means for improving the hole/electron ratio to achieve a high on/off ratio.

L. Ma et al., Applied Physics Letters 92 (2008) 063310 reported that the introduction of F₄TCNQ in very small quantities improved the performance of poly(3-hexylthiophene) (P3HT) thin film transistors. The field effect mobility of the devices was enhanced and the threshold voltages could be controlled by adjusting the F₄TCNQ concentration.

WO2010/063609 relates to an electronic device, which comprises a compound of the formula 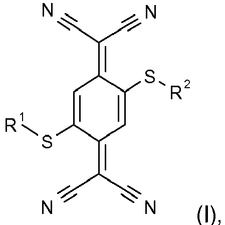 wherein
R¹ and R² independently of one another are C₁-C₁₂alkyl, C₁-C₁₂alkyl, which is interrupted by one, or more oxygen atoms, C₃-C₈cycloalkyl which is unsubstituted or substituted by C₁-C₄alkyl, unsubstituted C₆-C₁₂aryl, or C₃-C₇heteroaryl, or benzyl, or C₆-C₁₂aryl, or C₃-C₇heteroaryl, or benzyl which is substituted by F, Cl, Br, C₁-C₆alkyl, C₁-C₆alkoxy or di(C₁-C₆alkylamino).
The compound of the formula I is a n-type organic material, which is an intrinsically good semiconducting material, resulting in a high device stability and reliability.

Diketopyrrolopyrrole based polymers are, for example, described in WO2010/049321 and EP2034537.

It is the object of the present invention to provide new and improved organic field effect transistors (OFETs) to fabricate high quality OFETs by the choice of an ambipolar semiconductor material, which is described, for example, in WO2010/049321.

Said object has been solved by a semiconductor device, especially an organic field effect transistor, comprising a layer comprising a polymer comprising repeating units having a diketopyrrolopyrrole skeleton (DPP polymer) and an acceptor compound having an electron affinity in vacuum of 4.6 eV, or more; especially 4.8 eV, or more; very especially 5.0 eV, or more, which enables control of the charge carrier density.

In general, the acceptor compound has an electron affinity in vacuum of 6.0 eV, or less, especially 5.5 eV, or less. Accordingly, the acceptor compound has an electron affinity in vacuum of from 4.6 to 6.0 eV, especially 4.8 to 5.5 eV, very especially 5.0 to 5.5 eV.

In general "doping" means to add a foreign substance for controlling the property of a semiconductor (particulary, for controlling the conduction type of a semiconductor).

The doping of the DPP polymer with the acceptor compound leads to an organic field effect transistor with improved hole mobility, current on/off ratio (Iₒₙ/I_{off}) and controllable threshold shift.

Doping of the DPP polymers with acceptor compounds can lead to hole mobilities of greater than about 5x10⁻² cm²/Vs and Iₒₙ/I_{off} ratios of 10⁵ or higher.

In addition, the threshold voltage can be controlled by varying the doping concentration of the dopant material (acceptor compound). The threshold voltage can be extracted form the transfer characteristics according IEEE-1620 (Test Methods for the Characterization of Organic Transistors and Materials).

The doping concentration affects the on/off ratio and threshold voltage. The on/off ratio refers to the ratio of the source-drain current, when the transistor is on to the source-drain current, when the transistor is off. The gate voltage by which the source/drain current changes from on to off, i.e. the threshold value of the gate voltage, is an important parameter of the performance of the transistor.

The acceptor compound is contained in an amount of 0.1 to 8 % by weight, especially 0.5 to 5 % by weight, based on the amount of DPP polymer and acceptor compound. For field-effect transistors the doping ratio up to 8 wt% is relevant; doping more than 8 wt% leads to conductive polymers, which may be of interest as hole-injection layer for large scale applications (organic light emittiting devices (OLEDs), solar cells etc.).

Doping of the respective compound of formula I (DPP polymer; matrix material) with the dopants (acceptor compound) to be used according to the present invention may be produced by one or a combination of the following methods: a) sequential deposition of the matrix material and dopant with subsequent in-diffusion of the dopant by heat treatment; b) doping of a matrix material layer by a solution of dopant with subsequent evaporation of the solvent by heat treatment; and c) doping of a solution, or dispersion of the matrix material by a solution of dopant with subsequent evaporation of the solvent by heat treatment.

The "polymer comprising repeating units having a diketopyrrolopyrrole (DPP) skeleton" refers to a polymer having one or more DPP skeletons represented by the following formula 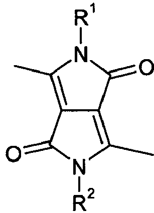 in the repeating unit.

The term polymer comprises oligomers as well as polymers. The oligomers of this invention have a weight average molecular weight of < 4,000 Daltons. The polymers of this invention preferably have a weight average molecular weight of 4,000 Daltons or greater, especially 4,000 to 2,000,000 Daltons, more preferably 10,000 to 1,000,000 and most preferably 10,000 to 100,000 Daltons. Molecular weights are determined according to high-temperature gel permeation chromatography (HT-GPC) using polystyrene standards.

In case of polymers of the formula 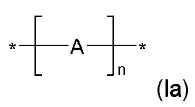 and 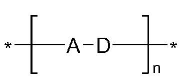 polymers are more preferred, wherein n is 4 (especially 10) to 1000, especially 4 (especially 10) to 200, very especially 5 (especially 20) to 100. Less preferred are oligomers of the formula **la** and **Ib,** wherein n is 2, or 3.

Examples of DPP polymers and their synthesis are, for example, described in US6451459B1, WO05/049695, WO2008/000664, WO2010/049321, WO2010/049323, WO2010/108873 (PCT/EP2010/053655), WO2010/115767 (PCT/EP2010/054152), WO2010/136353 (PCT/EP2010/056778), and WO2010/136352 (PCT/EP2010/056776); and can be selected from polymers of formula 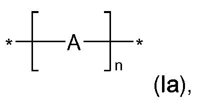 copolymers of formula 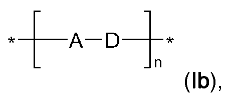 copolymers of formula 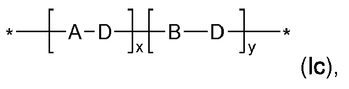 copolymers of formula 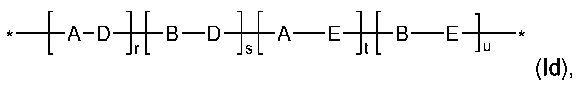 wherein
x = 0.995 to 0.005, y = 0.005 to 0.995, especially x = 0.2 to 0.8, y = 0.8 to 0.2, and wherein x + y = 1;
r = 0.985 to 0.005, s = 0.005 to 0.985, t = 0.005 to 0.985, u = 0.005 to 0.985, and wherein r + s + t + u = 1;
n is 4 to 1000, especially 4 to 200, very especially 5 to 100,
A is a group of formula 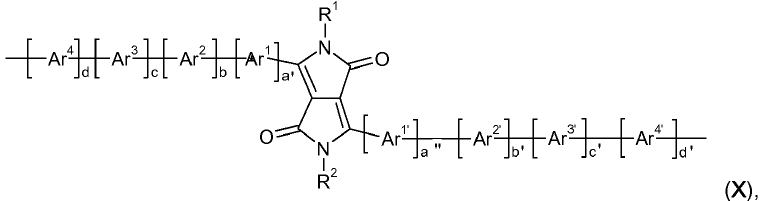
   wherein a' is 1, 2, or 3, a" is 0, 1, 2, or 3; b is 0, 1, 2, or 3; b' is 0, 1, 2, or 3; c is 0, 1, 2, or 3; c' is 0, 1, 2, or 3; d is 0, 1, 2, or 3; d' is 0, 1, 2, or 3; with the proviso that b' is not 0, if a" is 0;
   R¹ and R² may be the same or different and are selected from hydrogen, a C₁-C₁₀₀alkyl group, -COOR¹⁰⁶", a C₁-C₁₀₀alkyl group which is substituted by one or more halogen atoms, hydroxyl groups, nitro groups, -CN, or C₆-C₁₈aryl groups and/or interrupted by -O-, -COO-, -OCO-, or -S-; a C₇-C₁₀₀arylalkyl group, a carbamoyl group,C₅-C₁₂cycloalkyl, which can be substituted one to three times with C₁-C₈alkyl and/or C₁-C₈alkoxy, a C₆-C₂₄aryl group, in particular phenyl or 1- or 2-naphthyl which can be substituted one to three times with C₁-C₈alkyl, C₁-C₂₅thioalkoxy, and/or C₁-C₂₅alkoxy, or pentafluorophenyl,
   R^{106"} is C₁-C₅₀alkyl, especially C₄-C₂₅alkyl;
   Ar¹, Ar^{1'}, Ar², Ar^{2'}, Ar³, Ar^{3'}, Ar⁴ and Ar^{4'} are independently of each other heteroaromatic, or aromatic rings, which optionally can be condensed and/or substituted, especially 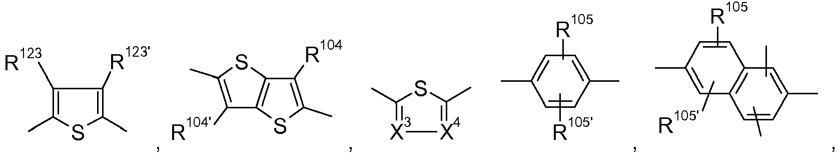 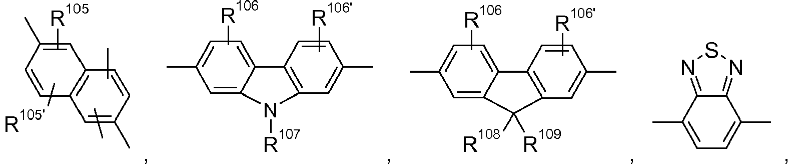 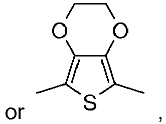 wherein
      one of X³ and X⁴ is N and the other is CR⁹⁹,
      R⁹⁹, R¹⁰⁴, R^{104'}, R¹²³ and R^{123'} are independently of each other hydrogen, halogen, especially F, or a C₁-C₂₅alkyl group, especially a C₄-C₂₅alkyl, which may optionally be interrupted by one or more oxygen or sulphur atoms, C₇-C₂₅arylalkyl, or a C₁-C₂₅alkoxy group, R¹⁰⁵, R^{105'}, R¹⁰⁶ and R^{106'} are independently of each other hydrogen, halogen, C₁-C₂₅alkyl, which may optionally be interrupted by one or more oxygen or sulphur atoms; C₇-C₂₅arylalkyl, or C₁-C₁₈alkoxy,
      R¹⁰⁷ is C₇-C₂₅arylalkyl, C₆-C₁₈aryl; C₆-C₁₈aryl which is substituted by C₁-C₁₈alkyl, C₁-C₁₈perfluoroalkyl, or C₁-C₁₈alkoxy; C₁-C₁₈alkyl; C₁-C₁₈alkyl which is interrupted by -O-, or-S-; or -COOR¹²⁴;
      R¹²⁴ is C₁-C₂₅alkyl group, especially a C₄-C₂₅alkyl, which may optionally be interrupted by one or more oxygen or sulphur atoms, C₇-C₂₅arylalkyl,
      R¹⁰⁸ and R¹⁰⁹ are independently of each other H, C₁-C₂₅alkyl, C₁-C₂₅alkyl which is substituted by E' and/or interrupted by D', C₇-C₂₅arylalkyl, C₆-C₂₄aryl, C₆-C₂₄aryl which is substituted by G, C₂-C₂₀heteroaryl, C₂-C₂₀heteroaryl which is substituted by G, C₂-C₁₈alkenyl, C₂-C₁₈alkynyl, C₁-C₁₈alkoxy, C₁-C₁₈alkoxy which is substituted by E' and/or interrupted by D', or C₇-C₂₅aralkyl, or
      R¹⁰⁸ and R¹⁰⁹ together form a group of formula =CR¹¹⁰R¹¹¹, wherein
      R¹¹⁰ and R¹¹¹ are independently of each other H, C₁-C₁₈alkyl, C₁-C₁₈alkyl which is substituted by E' and/or interrupted by D', C₆-C₂₄aryl, C₆-C₂₄aryl which is substituted by G, or C₂-C₂₀heteroaryl, or C₂-C₂₀heteroaryl which is substituted by G, or
      R¹⁰⁸ and R¹⁰⁹ together form a five or six membered ring, which optionally can be substituted by C₁-C₁₈alkyl, C₁-C₁₈alkyl which is substituted by E' and/or interrupted by D', C₆-C₂₄aryl, C₆-C₂₄aryl which is substituted by G, C₂-C₂₀heteroaryl, C₂-C₂₀heteroaryl which is substituted by G, C₂-C₁₈alkenyl, C₂-C₁₈alkynyl, C₁-C₁₈alkoxy, C₁-C₁₈alkoxy which is substituted by E' and/or interrupted by D', or C₇-C₂₅aralkyl,
      D' is -CO-, -COO-, -S-, -O-, or -NR¹¹²-,
      E' is C₁-C₈thioalkoxy, C₁-C₈alkoxy, CN, -NR¹¹²R¹¹³, -CONR¹¹²R¹¹³, or halogen,
      G is E', or C₁-C₁₈alkyl, and
      R¹¹² and R¹¹³ are independently of each other H; C₆-C₁₈aryl; C₆-C₁₈aryl which is substituted by C₁-C₁₈alkyl, or C₁-C₁₈alkoxy; C₁-C₁₈alkyl; or C₁-C₁₈alkyl which is interrupted by -O- and B, D and E are independently of each other a group of formula 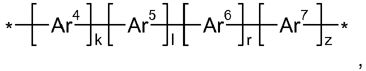 or formula **X,** with the proviso that in case B, D and E are a group of formula **X,** they are different from A, wherein
         k is 1,
         I is 0, or 1,
         r is 0, or 1,
         z is 0, or 1, and
         Ar⁴, Ar⁵, Ar⁶ and Ar⁷ are independently of each other a group of formula 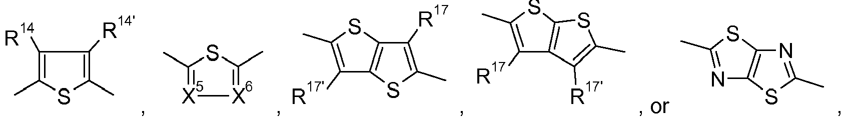 wherein one of X⁵ and X⁶ is N and the other is CR¹⁴,
            R¹⁴, R^{14'}, R¹⁷ and R^{17'} are independently of each other H, or a C₁-C₂₅alkyl group, especially a C₆-C₂₅alkyl, which may optionally be interrupted by one or more oxygen atoms.

Preferred polymers are described in WO2010/049321.

Ar¹ and Ar^{1'} are especially 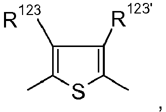 or 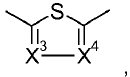 very especially 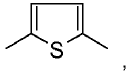 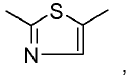 or 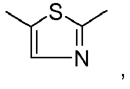 wherein 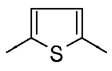 is most preferred.

Ar², Ar^{2'}, Ar³, Ar^{3'}, Ar⁴ and Ar^{4'} are especially 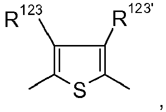 very especially

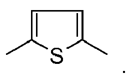

Additional preferred polymers are described in WO2010/108873.

Ar¹ and Ar^{1'} are especially 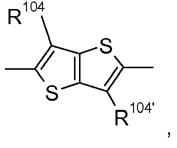 very especially

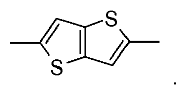

Ar², Ar^{2'}, Ar³, Ar^{3'}, Ar⁴ and Ar^{4'} are especially 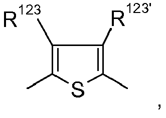 very especially

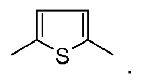

The group of formula 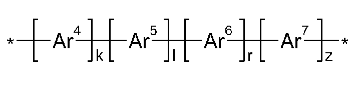 s preferably 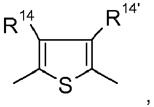 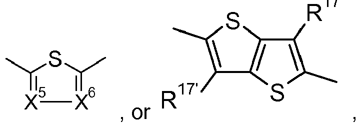 more preferably 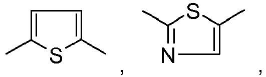 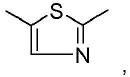 or 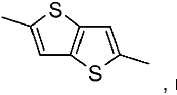 most preferred 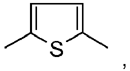 or

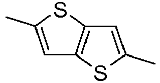

R¹ and R² may be the same or different and are preferably selected from hydrogen, a C₁-C₁₀₀alkyl group, especially a C₈-C₃₆alkyl group.

A is preferably selected from 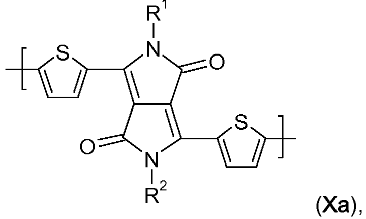 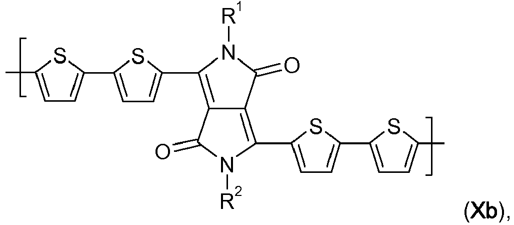 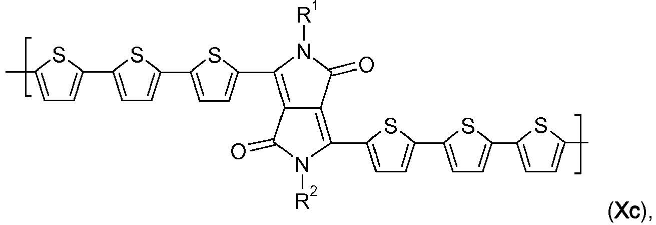 and

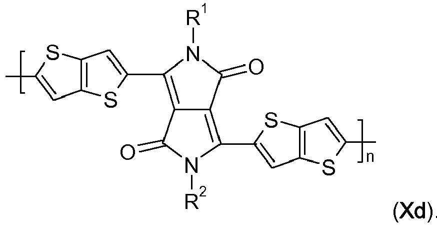

The group of formula 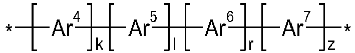 is preferably a group of formula 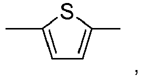 or

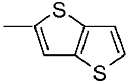

Examples of preferred DPP polymers of formula la are shown below: 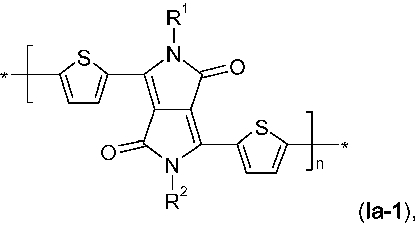 and

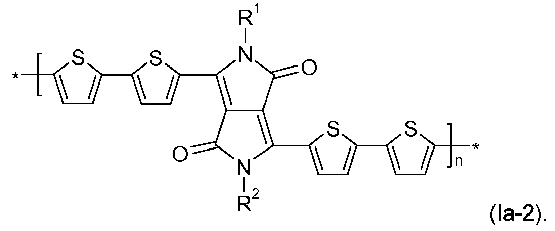

Examples of preferred DPP polymers of formula **Ib** are shown below: 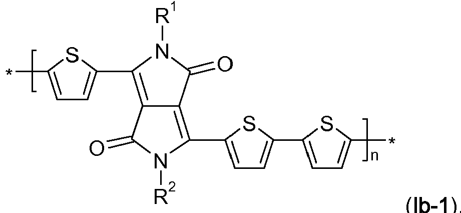 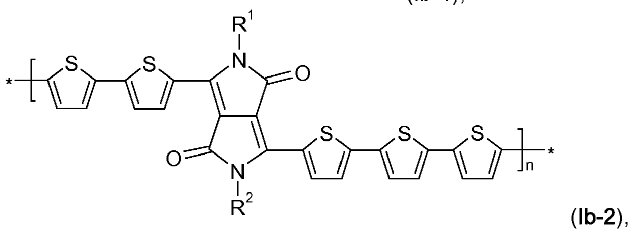 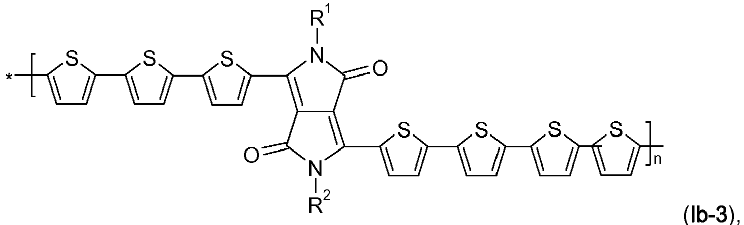 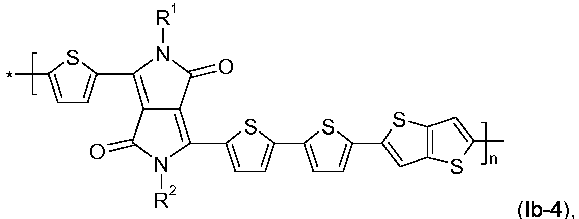 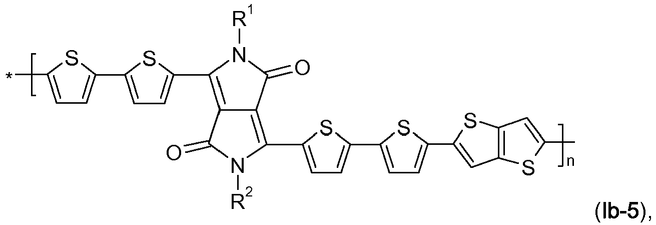 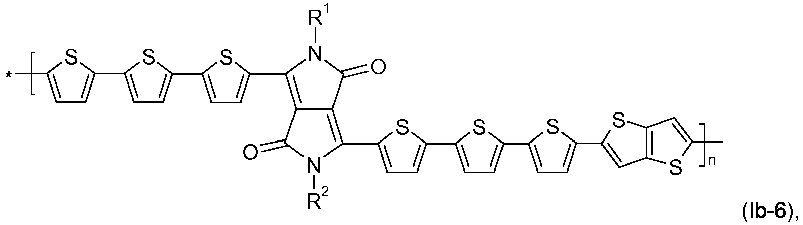 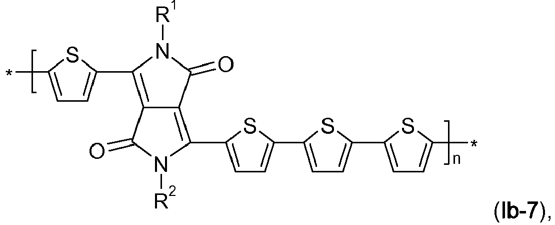 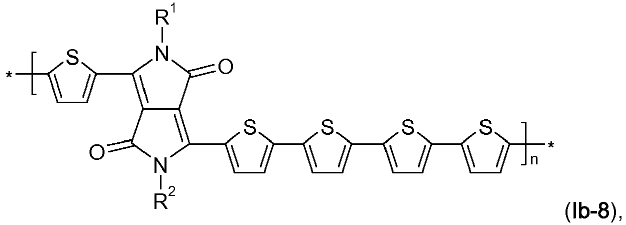 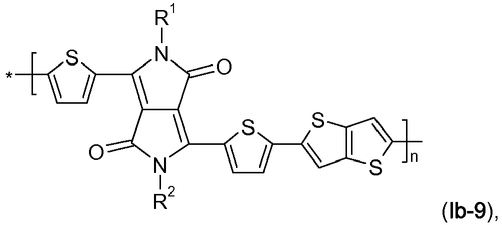 and 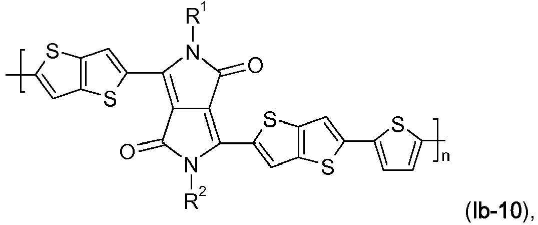 R¹ and R² are a C₁-C₃₆alkyl group, especially a C₈-C₃₆alkyl group. n is 4 to 1000, especially 4 to 200, very especially 5 to 100.

Examples of preferred DPP polymers of formula **Ic** are shown below: 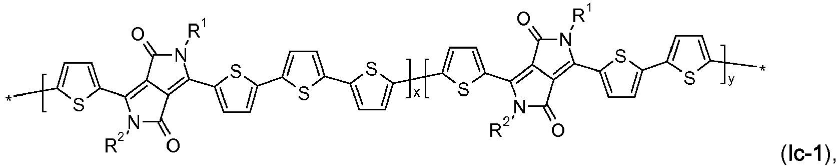 and 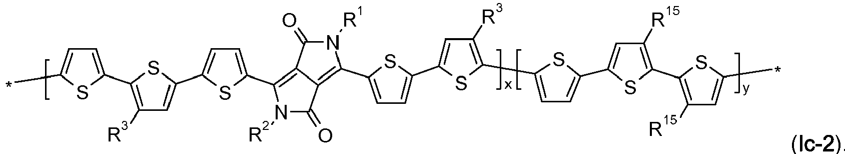 R¹ and R² are a C₁-C₃₆alkyl group, especially a C₈-C₃₆alkyl group. R³ is a C₁-C₁₈alkyl group. R¹⁵ is a C₄-C₁₈alkyl group. x = 0.995 to 0.005, y = 0.005 to 0.995, especially x = 0.4 to 0.9, y = 0.6 to 0.1, and wherein x + y = 1. Polymers of formula **Ic-1** are more preferred than polymers of formula **Ic-2.** The polymers preferably have a weight average molecular weight of 4,000 Daltons or greater, especially 4,000 to 2,000,000 Daltons, more preferably 10,000 to 1,000,000 and most preferably 10,000 to 100,000 Daltons.

Polymers of formula **Ib-1** are particularly preferred. Reference is, for example made to Example 1 of WO2010/049321: 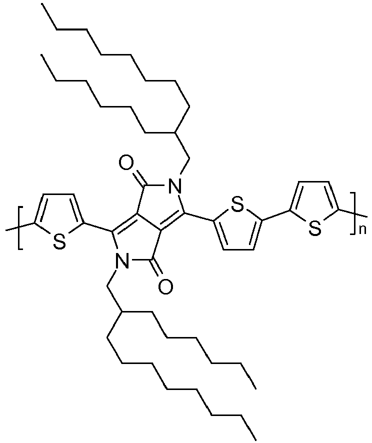 (Mw = 39'500, Polydispersity = 2.2 (measured by HT-GPC)).

The "acceptor compound" indicates a compound exhibiting electron accepting properties with respect to the above polymer compound and having an electron affinity of greater than 4.6 eV, especially greater than 4.8 eV, very especially greater than 5.0 eV.

Electron affinity (EA) is the energy released when the material accepts electrons from vacuum. Electron affinity is not directly related to the polarity of a material nor is there any correlation between electron affinity and dielectric constant.

According to the present invention, EA can be determined from cyclic voltammetry experiments for the organic semiconductor or from its measured ionization energy by subtracting the bandgap energy. The ionization energy (IE) of the material can be determined from standard ultraviolet photoemission spectroscopy (UPS) experiments. Alternatively, the EA of the organic semiconductor can be measured in a more direct way or by standard cyclic voltammetry. The condition for introducing charge transfer for supplying electrons form the donor polymer is that the highest occupied molecular orbital level of the donor (ionisation pontential corresponds to Ip) is over the lowest unoccupied molecular level of the acceptor molecule (expressed as electron affinity corresponding to EA)

The acceptor compounds are, for example, selected from quinoid compounds, such as a quinone or quinone derivative, 1,3,2-dioxaborines, a 1,3,2-dioxaborine derivatives, oxocarbon-, pseudooxocarbon- and radialene compounds and imidazole derivatives.

Such compounds have, for example, been described in K. Walzer, B. Maennig, M. Pfeiffer, and K. Leo, Chem. Rev. 107 (2007) 1233-1271, EP1596445A1 (quinone or a quinone derivative or a 1,3,2-dioxaborin or a 1,3,2-dioxaborin derivative), WO2009/003455A1 (quinoid compounds), WO2008/138580 (imidazole derivatives), and US2008/0265216 (oxocarbon-, pseudooxocarbon- and radialene compounds).

In a preferred embodiment of the present invention, the acceptor compound is a compound of formula 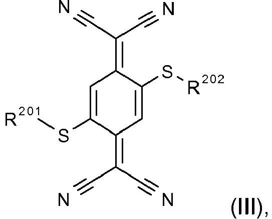 wherein
R²⁰¹ and R²⁰² independently of one another are C₁-C₁₂alkyl, C₁-C₁₂alkyl, which is interrupted by one, or more oxygen atoms, C₃-C₈cycloalkyl which is unsubstituted or substituted by C₁-C₄alkyl, unsubstituted C₆-C₁₂aryl, or C₃-C₇heteroaryl, or benzyl, or C₆-C₁₂aryl, or C₃-C₇heteroaryl, or benzyl which is substituted by F, Cl, Br, C₁-C₆alkyl, C₁-C₆alkoxy, or di(C₁-C₆alkylamino); or a compound of formula 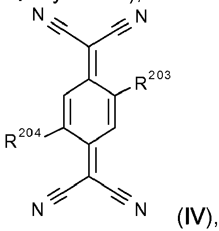 wherein R²⁰³ and R²⁰⁴ independently of one another are H, Cl, or C₁-C₂₅alkoxy. Compounds of formula III are, for example, described in US5281730, US5464697 and WO2010/063609 (PCT/EP2009/065687). Compounds of formula IV are, for example, described in EP860820. Specific examples of compounds of formula III and IV are shown below: 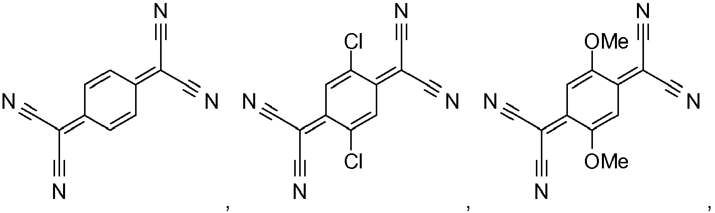 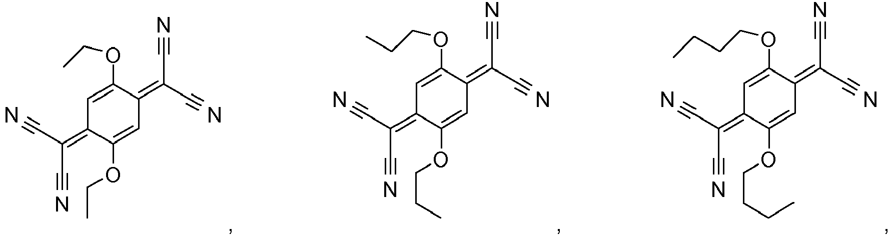 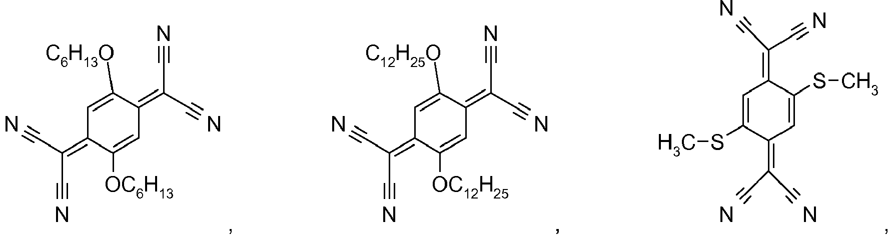 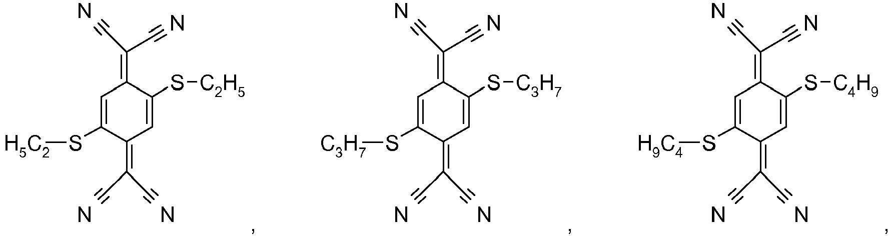 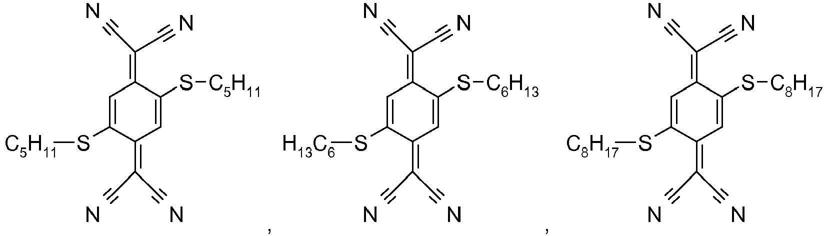 and

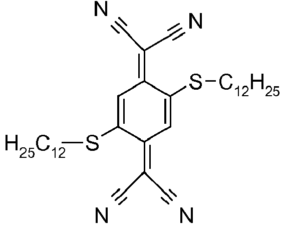

Further specific examples of the acceptor compound include 2-(6-dicyanomethylene-1,3,4,5,7,8-hexafluoro-6H-naphthalen-2-ylidene)-malononitrile, 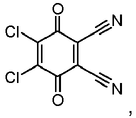 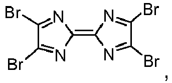 2,3,5,6-tetrafluoro-7,7,8,8-tetracyanoquinodimethane (F₄-TCNQ),

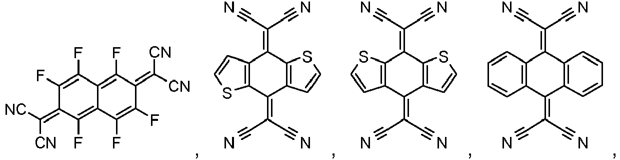

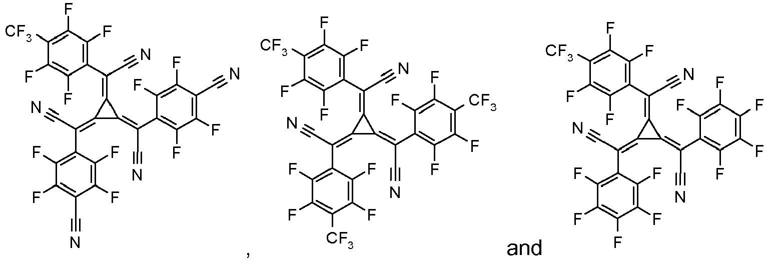

One of the acceptor compounds can be used alone, or two or more of these compounds can be used in combination.

The at present most preferred acceptor compound is F₄-TCNQ. Said derivative is particularly good at doping the DPP polymer, binding to source/drain electrodes, and providing a a good solubility in common solvents.

In a particularly preferred embodiment of the present invention the acceptor compound is 2,3,5,6-tetrafluoro-7,7,8,8-tetracyanoquinodimethane (F₄-TCNQ), and the DPP polymer is represented by formula 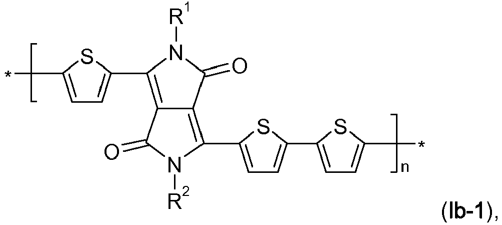 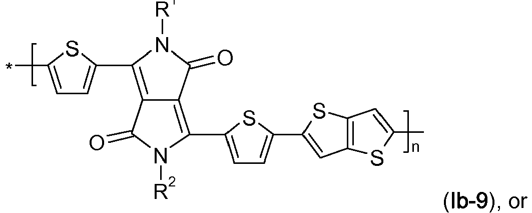 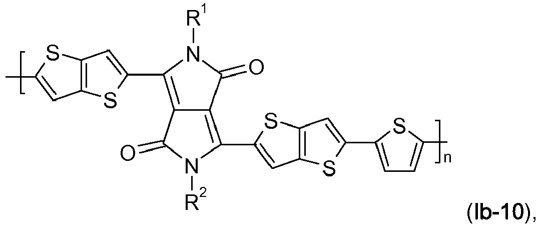 wherein n is 5 to 100 and R¹ and R² are a C₁-C₃₆alkyl group, especially a C₈-C₃₆alkyl group.

F₄-TCNQ is preferably used in an amount of 0.5 to 5 % by weight, based on the amount of DPP polymer **Ib-1** and acceptor compound.

Halogen is fluorine, chlorine, bromine and iodine, especially fluorine.

C₁-C₂₅alkyl (C₁-C₁₈alkyl) is typically linear or branched, where possible. Examples are methyl, ethyl, n-propyl, isopropyl, n-butyl, sec.-butyl, isobutyl, tert.-butyl, n-pentyl, 2-pentyl, 3-pentyl, 2,2-dimethylpropyl, 1,1,3,3-tetramethylpentyl, n-hexyl, 1-methylhexyl, 1,1,3,3,5,5-hexamethylhexyl, n-heptyl, isoheptyl, 1,1,3,3-tetramethylbutyl, 1-methylheptyl, 3-methylheptyl, n-octyl, 1,1,3,3-tetramethylbutyl and 2-ethylhexyl, n-nonyl, decyl, undecyl, dodecyl, tridecyl, tetradecyl, pentadecyl, hexadecyl, heptadecyl, octadecyl, eicosyl, heneicosyl, docosyl, tetracosyl or pentacosyl. C₁-C₈alkyl is typically methyl, ethyl, n-propyl, isopropyl, n-butyl, sec.-butyl, isobutyl, tert.-butyl, n-pentyl, 2-pentyl, 3-pentyl, 2,2-dimethyl-propyl, n-hexyl, n-heptyl, n-octyl, 1,1,3,3-tetramethylbutyl and 2-ethylhexyl. C₁-C₄alkyl is typically methyl, ethyl, n-propyl, isopropyl, n-butyl, sec.-butyl, isobutyl, tert.-butyl.

C₁-C₂₅alkoxy (C₁-C₁₈alkoxy) groups are straight-chain or branched alkoxy groups, e.g. methoxy, ethoxy, n-propoxy, isopropoxy, n-butoxy, sec-butoxy, tert-butoxy, amyloxy, isoamyloxy or tert-amyloxy, heptyloxy, octyloxy, isooctyloxy, nonyloxy, decyloxy, undecyloxy, dodecyloxy, tetradecyloxy, pentadecyloxy, hexadecyloxy, heptadecyloxy and octadecyloxy. Examples of C₁-C₈alkoxy are methoxy, ethoxy, n-propoxy, isopropoxy, n-butoxy, sec.-butoxy, isobutoxy, tert.-butoxy, n-pentoxy, 2-pentoxy, 3-pentoxy, 2,2-dimethylpropoxy, n-hexoxy, n-heptoxy, n-octoxy, 1,1,3,3-tetramethylbutoxy and 2-ethylhexoxy, preferably C₁-C₄alkoxy such as typically methoxy, ethoxy, n-propoxy, isopropoxy, n-butoxy, sec.-butoxy, isobutoxy, tert.-butoxy. The term "alkylthio group" means the same groups as the alkoxy groups, except that the oxygen atom of the ether linkage is replaced by a sulfur atom.

C₂-C₂₅alkenyl (C₂-C₁₈alkenyl) groups are straight-chain or branched alkenyl groups, such as e.g. vinyl, allyl, methallyl, isopropenyl, 2-butenyl, 3-butenyl, isobutenyl, n-penta-2,4-dienyl, 3-methyl-but-2-enyl, n-oct-2-enyl, n-dodec-2-enyl, isododecenyl, n-dodec-2-enyl or n-octadec-4-enyl.

C₂₋₂₄alkynyl (C₂₋₁₈alkynyl) is straight-chain or branched and preferably C₂₋₈alkynyl, which may be unsubstituted or substituted, such as, for example, ethynyl, 1-propyn-3-yl, 1-butyn-4-yl, 1-pentyn-5-yl, 2-methyl-3-butyn-2-yl, 1,4-pentadiyn-3-yl, 1,3-pentadiyn-5-yl, 1-hexyn-6-yl, cis-3-methyl-2-penten-4-yn-1-yl, trans-3-methyl-2-penten-4-yn-1-yl, 1,3-hexadiyn-5-yl, 1-octyn-8-yl, 1-nonyn-9-yl, 1-decyn-10-yl, or 1-tetracosyn-24-yl.

C₅-C₁₂cycloalkyl is typically cyclopentyl, cyclohexyl, cycloheptyl, cyclooctyl, cyclononyl, cyclodecyl, cycloundecyl, cyclododecyl, preferably cyclopentyl, cyclohexyl, cycloheptyl, or cyclooctyl, which may be unsubstituted or substituted. The cycloalkyl group, in particular a cyclohexyl group, can be condensed one or two times by phenyl which can be substituted one to three times with C₁-C₄-alkyl, halogen and cyano. Examples of such condensed cyclohexyl groups are: 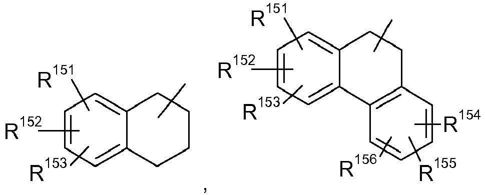 or 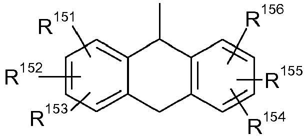 in particular 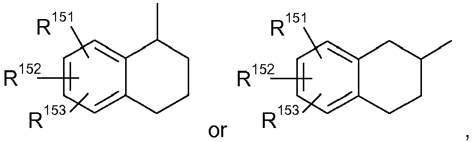 wherein R¹⁵¹, R¹⁵², R¹⁵³, R¹⁵⁴, R¹⁵⁵ and R¹¹³ are independently of each other C₁-C₈-alkyl, C₁-C₈-alkoxy, halogen and cyano, in particular hydrogen.

C₆-C₂₄aryl (C₆-C₂₄aryl) is typically phenyl, indenyl, azulenyl, naphthyl, biphenyl, as-indacenyl, s-indacenyl, acenaphthylenyl, fluorenyl, phenanthryl, fluoranthenyl, triphenlenyl, chrysenyl, naphthacen, picenyl, perylenyl, pentaphenyl, hexacenyl, pyrenyl, or anthracenyl, preferably phenyl, 1-naphthyl, 2-naphthyl, 4-biphenyl, 9-phenanthryl, 2- or 9-fluorenyl, 3- or 4-biphenyl, which may be unsubstituted or substituted. Examples of C₆-C₁₂aryl are phenyl, 1-naphthyl, 2-naphthyl, 3- or 4-biphenyl, 2- or 9-fluorenyl or 9-phenanthryl, which may be unsubstituted or substituted.

C₇-C₂₅aralkyl is typically benzyl, 2-benzyl-2-propyl, β-phenyl-ethyl, α,α-dimethylbenzyl, ω-phenyl-butyl, ω,ω-dimethyl-ω-phenyl-butyl, ω-phenyl-dodecyl, ω-phenyl-octadecyl, ω-phenyl-eicosyl or ω-phenyl-docosyl, preferably C₇-C₁₈aralkyl such as benzyl, 2-benzyl-2-propyl, β-phenyl-ethyl, α,α-dimethylbenzyl, ω-phenyl-butyl, ω,ω-dimethyl-ω-phenyl-butyl, ω-phenyl-dodecyl or ω-phenyl-octadecyl, and particularly preferred C₇-C₁₂aralkyl such as benzyl, 2-benzyl-2-propyl, β-phenyl-ethyl, α,α-dimethylbenzyl, ω-phenyl-butyl, or ω,ω-dimethyl-ω-phenyl-butyl, in which both the aliphatic hydrocarbon group and aromatic hydrocarbon group may be unsubstituted or substituted. Preferred examples are benzyl, 2-phenylethyl, 3-phenylpropyl, naphthylethyl, naphthylmethyl, and cumyl.

The term "carbamoyl group" is typically a C₁-₁₈carbamoyl radical, preferably C₁₋₈carbamoyl radical, which may be unsubstituted or substituted, such as, for example, carbamoyl, methylcarbamoyl, ethylcarbamoyl, n-butylcarbamoyl, tert-butylcarbamoyl, dimethylcarbamoyloxy, morpholinocarbamoyl or pyrrolidinocarbamoyl.

Heteroaryl is typically C₂-C₂₆heteroaryl (C₂-C₂₀heteroaryl), i.e. a ring with five to seven ring atoms or a condensed ring system, wherein nitrogen, oxygen or sulfur are the possible hetero atoms, and is typically an unsaturated heterocyclic group with five to 30 atoms having at least six conjugated π-electrons such as thienyl, benzo[b]thienyl, dibenzo[b,d]thienyl, thianthrenyl, furyl, furfuryl, 2H-pyranyl, benzofuranyl, isobenzofuranyl, dibenzofuranyl, phenoxythienyl, pyrrolyl, imidazolyl, pyrazolyl, pyridyl, bipyridyl, triazinyl, pyrimidinyl, pyrazinyl, pyridazinyl, indolizinyl, isoindolyl, indolyl, indazolyl, purinyl, quinolizinyl, chinolyl, isochinolyl, phthalazinyl, naphthyridinyl, chinoxalinyl, chinazolinyl, cinnolinyl, pteridinyl, carbazolyl, carbolinyl, benzotriazolyl, benzoxazolyl, phenanthridinyl, acridinyl, pyrimidinyl, phenanthrolinyl, phenazinyl, isothiazolyl, phenothiazinyl, isoxazolyl, furazanyl or phenoxazinyl, which can be unsubstituted or substituted.

Possible substituents of the above-mentioned groups are C₁-C₈alkyl, a hydroxyl group, a mercapto group, C₁-C₈alkoxy, C₁-C₈alkylthio, halogen, halo-C₁-C₈alkyl, a cyano group, a carbamoyl group, a nitro group or a silyl group, especially C₁-C₈alkyl, C₁-C₈alkoxy, C₁-C₈alkylthio, halogen, halo-C₁-C₈alkyl, or a cyano group.

As described above, the aforementioned groups may be substituted by E' and/or, if desired, interrupted by D'. Interruptions are of course possible only in the case of groups containing at least 2 carbon atoms connected to one another by single bonds; C₆-C₁₈aryl is not interrupted; interrupted arylalkyl or alkylaryl contains the unit D' in the alkyl moiety. C₁-C₁₈alkyl substituted by one or more E' and/or interrupted by one or more units D' is, for example, (CH₂CH₂O)₁₋₉-R^{x}, where R^{x} is H or C₁-C₁₀alkyl or C₂-C₁₀alkanoyl (e.g. CO-CH(C₂H₅)C₄H₉), CH₂-CH(OR^{y'})-CH₂-O-R^{y}, where R^{y} is C₁-C₁₈alkyl, C₅-C₁₂cycloalkyl, phenyl, C₇-C₁₅phenylalkyl, and R^{y'} embraces the same definitions as R^{y} or is H; C₁-C₈alkylene-COO-R^{z}, e.g. CH₂COOR^{z}, CH(CH₃)COOR^{z}, C(CH₃)₂COOR^{z}, where R^{z} is H, C₁-C₁₈alkyl, (CH₂CH₂O)₁₋₉-R^{x}, and R^{x} embraces the definitions indicated above; CH₂CH₂-O-CO-CH=CH₂; CH₂CH(OH)CH₂-O-CO-C(CH₃)=CH₂.

The semiconductor device according to the present invention is preferably an organic field effect transistor. The organic field effect transistor comprises a gate electrode, a gate insulating layer, a semiconductor layer, a source electrode, and a drain electrode, the semiconductor layer represents the layer comprising the DPP polymer and the acceptor compound.

The organic semi-conductive material (DPP polymer and the acceptor compound) is solution processable, i.e. it may be deposited by, for example, inkjet printing.

An OFET device according to the present invention preferably comprises:
- a source electrode,
- a drain electrode,
- a gate electrode,
- a semiconducting layer,
- one or more gate insulator layers, and
- optionally a substrate, wherein the semiconductor layer comprises the DPP polymer and the acceptor compound.

The gate, source and drain electrodes and the insulating and semiconducting layer in the OFET device may be arranged in any sequence, provided that the source and drain electrode are separated from the gate electrode by the insulating layer, the gate electrode and the semiconductor layer both contact the insulating layer, and the source electrode and the drain electrode both contact the semiconducting layer.

Preferably the OFET comprises an insulator having a first side and a second side, a gate electrode located on the first side of the insulator, a layer comprising the DPP polymer and the acceptor compound located on the second side of the insulator, and a drain electrode and a source electrode located on the polymer layer.

The OFET device can be a top gate device or a bottom gate device.

Suitable structures and manufacturing methods of an OFET device are known to the person skilled in the art and are described in the literature, for example in WO03/052841.

Typically the semiconducting layer of the present invention is at most 1 micron (=1 µm) thick, although it may be thicker if required. For various electronic device applications, the thickness may also be less than about 1 micron thick. For example, for use in an OFET the layer thickness may typically be 100 nm or less. The exact thickness of the layer will depend, for example, upon the requirements of the electronic device in which the layer is used.

The insulator layer (dielectric layer) generally can be an inorganic material film or an organic polymer film. Illustrative examples of inorganic materials suitable as the gate dielectric layer include silicon oxide, silicon nitride, aluminum oxide, barium titanate, barium zirconium titanate and the like. Illustrative examples of organic polymers for the gate dielectric layer include polyesters, polycarbonates, poly(vinyl phenol), polyimides, polystyrene, poly(methacrylate)s, poly(acrylate)s, epoxy resin, photosensitive resists as described in WO07/113107 and the like. In the exemplary embodiment, a thermally grown silicon oxide (SiO₂) may be used as the dielectric layer.

The thickness of the dielectric layer is, for example from about 10 nanometers to about 2000 nanometers depending on the dielectric constant of the dielectric material used. A representative thickness of the dielectric layer is from about 100 nanometers to about 500 nanometers. The dielectric layer may have a conductivity that is for example less than about 10⁻¹² S/cm.

The gate insulator layer may comprise, for example, a fluoropolymer, like e.g. the commercially available Cytop 809M®, or Cytop 107M® (from Asahi Glass). Preferably the gate insulator layer is deposited, e.g. by spin-coating, doctor blading, wire bar coating, spray or dip coating or other known methods, from a formulation comprising an insulator material and one or more solvents with one or more fluoro atoms (fluorosolvents), preferably a perfluorosolvent. A suitable perfluorosolvent is e.g. FC75® (available from Acros, catalogue number 12380). Other suitable fluoropolymers and fluorosolvents are known in prior art, like for example the perfluoropolymers Teflon AF® 1600 or 2400 (from DuPont), or Fluoropel® (from Cytonix) or the perfluorosolvent FC 43® (Acros, No. 12377).

In order to form the organic active layer using the DPP polymer and the acceptor compound, a composition for the organic active layer including chloroform or chlorobenzene may be used. Examples of the solvent used in the composition for the organic active layer may include chloroform, chlorobenzene, dichlorobenzene, trichlorobenzene, and toluene, or mixtures thereof.

Examples of the process of forming the organic active layer may include, but may not be limited to, screen printing, printing, spin coating, dipping or ink jetting.

As such, in the gate insulating layer (gate dielectric) included in the OFET any insulator having a high dielectric constant may be used as long as it is typically known in the art. Specific examples thereof may include, but may not be limited to, a ferroelectric insulator, including Bao.₃₃Sr_{0.66}TiO₃ (BST: Barium Strontium Titanate), Al₂O₃, Ta₂O₅, La₂O₅, Y₂O₅, or TiO₂, an inorganic insulator, including PbZr_{0.33}Ti_{0.66}O₃ (PZT), Bi₄Ti₃O₁₂, BaMgF₄, SrBi₂(TaNb)₂O₉, Ba(ZrTi)O₃(BZT), BaTiO₃, SrTiO₃, Bi₄Ti₃O₁₂, SiO₂, SiNₓ, or AION, or an organic insulator, including polyimide, benzocyclobutane (BCB), parylene, polyvinylalcohol, polyvinylphenol, polyvinylpyrrolidine (PVP), acrylates such as polymethylmethacrylate (PMMA) and benzocyclobutanes (BCBs). The insulating layer may be formed from a blend of materials or comprise a multi-layered structure. The dielectric material may be deposited by thermal evaporation, vacuum processing or lamination techniques as are known in the art. Alternatively, the dielectric material may be deposited from solution using, for example, spin coating or ink jet printing techniques and other solution deposition techniques.

If the dielectric material is deposited from solution onto the organic semiconductor, it should not result in dissolution of the organic semiconductor. Likewise, the dielectric material should not be dissolved if the organic semiconductor is deposited onto it from solution. Techniques to avoid such dissolution include: use of orthogonal solvents, that is use of a solvent for deposition of the uppermost layer that does not dissolve the underlying layer, and crosslinking of the underlying layer. The thickness of the insulating layer is preferably less than 2 micrometres, more preferably less than 500 nm.

In the gate electrode and the source/drain electrodes included in the OFET of the present invention, a typical metal may be used, specific examples thereof include, but are not limited to, platinum(Pt), palladium (Pd), gold (Au), silver (Ag), copper (Cu), aluminum (Al), nickel (Ni). Alloys and oxides, such as molybdenum trioxide and indium tin oxide (ITO), may also be used. Preferably, the material of at least one of the gate, source and drain electrodes is selected from the group Cu, Ag, Au or alloys thereof. The source and drain electrodes may be deposited by thermal evaporation and patterned using standard photolithography and lift off techniques as are known in the art.

The substrate may be rigid or flexible. Rigid substrates may be selected from glass or silicon and flexible substrates may comprise thin glass or plastics such as poly (ethylene terephthalate) (PET), polyethylenenaphthalate (PEN), polycarbonate, polycarbonate, polyvinylalcohol, polyacrylate, polyimide, polynorbornene, and polyethersulfone (PES).

Alternatively, conductive polymers may be deposited as the source and drain electrodes. An example of such a conductive polymers is poly(ethylene dioxythiophene) (PEDOT) although other conductive polymers are known in the art. Such conductive polymers may be deposited from solution using, for example, spin coating or ink jet printing techniques and other solution deposition techniques.

The source and drain electrodes are preferably formed from the same material for ease of manufacture. However, it will be appreciated that the source and drain electrodes may be formed of different materials for optimisation of charge injection and extraction respectively.

Typical thicknesses of source and drain electrodes are about, for example, from about 40 nanometers to about 1 micrometer with the more specific thickness being about 100 to about 400 nanometers.

The length of the channel defined between the source and drain electrodes may be up to 500 microns, but preferably the length is less than 200 microns, more preferably less than 100 microns, most preferably less than 20 microns.

Other layers may be included in the device architecture. For example, a self assembled monolayer (SAM) may be deposited on the gate, source or drain electrodes, substrate, insulating layer and organic semiconductor material to promote crystallity, reduce contact resistance, repair surface characteristics and promote adhesion where required. Exemplary materials for such a monolayer include chloro- or alkoxy-silanes with long alkyl chains, eg octadecyltrichlorosilane.

The method of fabricating an ambipolar organic thin film transistor may include forming a gate electrode, a gate insulating layer, an organic active layer, and source/drain electrodes on a substrate, wherein the organic active layer (semiconductor layer) includes the DPP polymer and the acceptor compound. The organic active layer may be formed into a thin film through screen printing, printing, spin coating, dipping or ink jetting. The insulating layer may be formed using material selected from the group consisting of a ferroelectric insulator, including Ba_{0.33}Sr_{0.66}TiO₃ (BST: Barium Strontium Titanate), Al₂O₃, Ta₂O₅, La₂O₅, Y₂O₅, or TiO₂, an inorganic insulator, including PbZr_{0.33}Ti_{0.66}O₃ (PZT), Bi₄Ti₃O₁₂, BaMgF₄, SrBi₂(TaNb)₂O₉, Ba(ZrTi)O₃(BZT), BaTiO₃, SrTiO₃, Bi₄Ti₃O₁₂, SiO₂, SiNₓ, or AION, or an organic insulator, including polyimide, benzocyclobutane (BCB), parylene, polyvinylalcohol, or polyvinylphenol. The substrate may be formed using material selected from the group consisting of glass, polyethylenenaphthalate (PEN), polyethyleneterephthalate (PET), polycarbonate, polyvinylalcohol, polyacrylate, polyimide, polynorbornene, and polyethersulfone (PES). The gate electrode and the source/drain electrodes may be formed using material selected from the group consisting of gold (Au), silver (Ag), copper (Cu), aluminum (Al), nickel (Ni), and indium tin oxide (ITO).

The method of manufacturing the organic thin film transistor may comprise: depositing a source and drain electrode; forming a semiconductive layer on the source and drain electrodes, the semiconductive layer of comprising the DPP polymer and the acceptor compound in a channel region between the source and drain electrode. The organic semi-conductive material is preferably deposited from solution. Preferred solution deposition techniques include spin coating and ink jet printing. Other solution deposition techniques include dip-coating, roll printing and screen printing.

A bottom-gate OFET device may be formed using the method illustrated below.
1. Gate deposition and patterning (e.g. patterning of an ITO-coated substrate).
2. Dielectric deposition and patterning (e.g. cross- linkable, photopatternable dielectrics).
3. Source-drain material deposition and patterning (e.g. silver, photolithography).
4. Source-drain surface treatment. The surface treatment groups could be applied by dipping the substrate into a solution of the self-assembled material, or applying by spin coating from a dilute solution. Excess (un-attached) material can be removed by washing.
5. Deposition of the organic semiconductive material (e.g. by ink jet printing).

This technique is also compatible with top-gate devices. In this case, the source-drain layer is deposited and patterned first. The surface treatment is then applied to the source-drain layer prior to organic semiconductive material, gate dielectric and gate deposition.

OFETs have a wide range of possible applications. One such application is to drive pixels in an optical device (apparatus), preferably an organic optical device. Examples of such optical devices include photoresponsive devices, in particular photodetectors , and light-emissive devices, in particular organic light emitting devices. High mobility OTFTs are particularly suited as backplanes for use with active matrix organic light emitting devices, e.g. for use in display applications.

The following examples are included for illustrative purposes only and do not limit the scope of the claims. Unless otherwise stated, all parts and percentages are by weight.

### Examples

### Application Example

Bottom-gate thin film transistor (TFT) structures with p-Si gate (10 Ωcm) are used for all experiments. A high-quality thermal SiO₂ layer of 300 nm thickness serves as gate-insulator of Cᵢ=32.6 nF/cm² capacitance per unit area. Source and drain electrodes are patterned by photolithography directly on the gate-oxide. Gold source drain electrodes defining channels of width W=10 mm and varying lengths L= 2.5, 5, 10, 20 µm are used. Prior to deposition of the organic semiconductor the SiO₂ surface is treated at 60°C with a 0.1 m solution of octadecyltrichlorosilane (OTS) in toluene for 20 minutes. After rinsing with isopropanol the substrates are dried. Small quantities of F₄TCNQ (Aldrich Company) are dissolved in o-xylene (puriss.) and then mixed with the DPP-polymer of formula 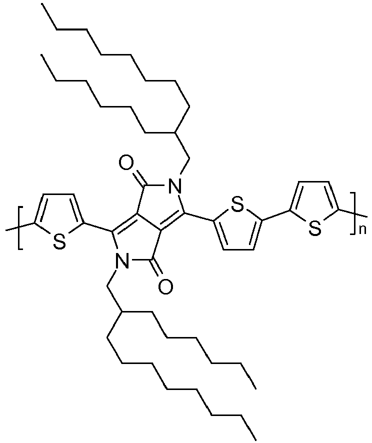 (obtained according to Example 1 of WO2010/049321) in the following weight ratios: 0/100, 0.5/99.5, 1/99, 3/97, 6/94, and 8/92 (dopant to polymer weight ratio) to generate 0.5 % by weight (5 mg DPP polymer in 10 mg o- xylene) starting solution. To improve the solubility the solutions are heated up to 80° C. The semiconductor thin film is prepared by spin-coating of the doped solution. Before use the solution is filtered through a 0.2 µm filter. The spin coating is accomplished at a spinning speed of 3000 rpm for about 20 seconds in ambient conditions to fabricate thin films (30-50 nm). The devices are dried at 150°C for 15 minutes before evaluation.

### Transistor Performance

The transistor behaviour is measured on an automated (transistor prober TP-10, CSEM) using an Agilent 4155 C semiconductor parameter analyzer. The transfer characteristic is measured on devices with various channel length prepared in the same run. The field-effect mobilities are calculated in the saturation regime at V_{d}= -30V. From these characteristics, the threshold voltage (Vₜ) is extracted form the peak of the second derivative of the gate voltage dependent drain current as described in IEEE-1620. According to the transfer line method the contact resistance is computed at a source- drain voltage of 1V. The on/off currents are obtained at V_{gs}= -30V and V_{ds} =-30V, V_{gs} = 10V and V_{ds}= - 30 V, respectively.

Table 1 below shows the device characteristics of the DPP-based polymer doped with various F₄-TCNQ amounts.

**Table 1**

| **Device** | **F₄-TCNQ¹⁾** | **µ^{avg} (cm²/Vs)** | **Iₒₙ/ I_{off}** | **Vₜ(V)** |
|---|---|---|---|---|
| Comp. Appl. Ex. 1 | 0.0 | 0.096 | 2.5 x10³ | -9.0 |
| Appl. Ex. 1 | 0.5 | 0.053 | 2.6 x10⁵ | -4.0 |
| Appl. Ex. 2 | 1.0 | 0.069 | 7.3x10⁵ | 0.6 |
| Appl. Ex. 3 | 3.0 | 0.082 | 3.4 x10⁵ | 4.8 |
| Appl. Ex. 4 | 6.0 | 0.063 | 3.4 x10⁴ | 12.1 |
| Appl. Ex. 5 | 8.0 | 0.043 | 3.9x10¹ | 17.6 |

| | | | | |
|---|---|---|---|---|
| ¹⁾ amount of F₄-TCNQ in % by weight based on the amount of F₄-TCNQ and DPP polymer. | | | | |

## Claims

1. A semiconductor device, comprising a layer comprising a polymer comprising repeating units having a diketopyrrolopyrrole skeleton (DPP polymer) and an acceptor compound having an electron affinity (in vacuum) of 4.6 eV, or more, wherein the acceptor compound is contained in an amount of 0.1 to 8 % by weight, based on the amount of DPP polymer and acceptor compound.

2. The semiconductor device according to claim 1, which is an organic field effect transistor.

3. The semiconductor device according to claim 2, wherein the organic field effect transistor comprises a gate electrode, a gate insulating layer, a semiconductor layer, a source electrode, and a drain electrode, the semiconductor layer represents the layer comprising the DPP polymer and the acceptor compound.

4. The semiconductor device according to any of claims 1 to 3, wherein the DPP polymer is selected from polymers of formula 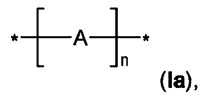 copolymers of formula 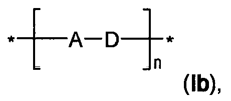 copolymers of formula 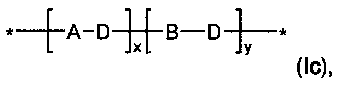 copolymers of formula 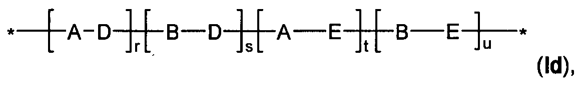 wherein
x = 0.995 to 0.005, y = 0.005 to 0.995, especially x = 0.2 to 0.8, y = 0.8 to 0.2, and wherein x + y = 1;
r = 0.985 to 0.005, s = 0.005 to 0.985, t = 0.005 to 0.985, u = 0.005 to 0.985, and wherein r + s + t + u = 1;
n is 4 to 1000, especially 4 to 200, very especially 5 to 100,
A is a group of formula 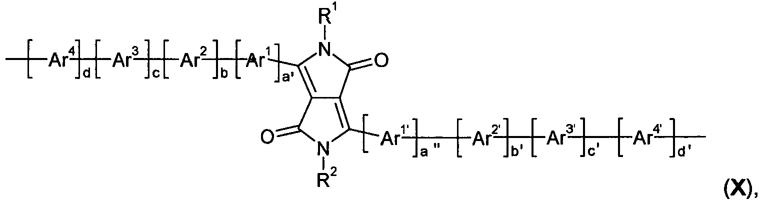
wherein a' is 1, 2, or 3, a" is 0, 1, 2, or 3; b is 0, 1, 2, or 3; b' is 0, 1, 2, or 3; c is 0, 1, 2, or 3; c' is 0, 1, 2, or 3; d is 0, 1, 2, or 3; d' is 0, 1, 2, or 3; with the proviso that b' is not 0, if a" is 0;
R¹ and R² may be the same or different and are selected from hydrogen, a C₁-C₁₀₀alkyl group, -COOR^{106"}, a C₁-C₁₀₀alkyl group which is substituted by one or more halogen atoms, hydroxyl groups, nitro groups, -CN, or C₆-C₁₈aryl groups and/or interrupted by -O-, -COO-, -OCO-, or -S-; a C₇-C₁₀₀arylalkyl group, a carbamoyl group,C₅-C₁₂cycloalkyl, which can be substituted one to three times with C₁-C₈alkyl and/or C₁-C₈alkoxy, a C₆-C₂₄aryl group, in particular phenyl or 1- or 2-naphthyl which can be substituted one to three times with C₁-C₈alkyl, C₁-C₂₅thioalkoxy, and/or C₁-C₂₅alkoxy, or pentafluorophenyl,
R^{106"} is C₁-C₅₀alkyl, especially C₄-C₂₅alkyl;
Ar¹, Ar^{1'}, Ar², Ar^{2'}, Ar³, Ar^{3'}, Ar⁴ and Ar^{4'} are independently of each other heteroaromatic, or aromatic rings, which optionally can be condensed and/or substituted, especially 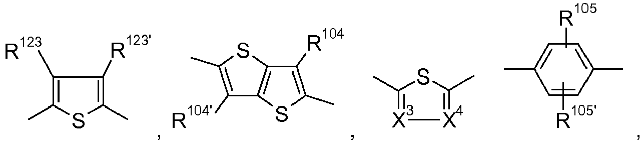 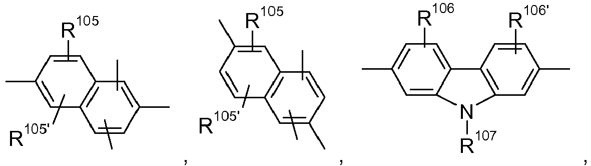 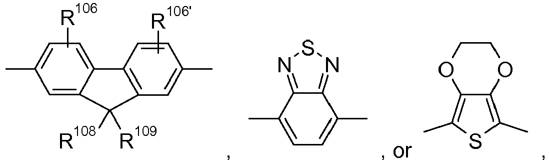 wherein
one of X³ and X⁴ is N and the other is CR⁹⁹,
R⁹⁹, R¹⁰⁴, R^{104'}, R¹²³ and R^{123'} are independently of each other hydrogen, halogen, especially F, or a C₁-C₂₅alkyl group, especially a C₄-C₂₅alkyl, which may optionally be interrupted by one or more oxygen or sulphur atoms, C₇-C₂₅arylalkyl, or a C₁-C₂₅alkoxy group,
R¹⁰⁵, R^{105'}, R¹⁰⁶ and R^{106'} are independently of each other hydrogen, halogen, C₁-C₂₅alkyl, which may optionally be interrupted by one or more oxygen or sulphur atoms; C₇-C₂₅arylalkyl, or C₁-C₁₈alkoxy,
R¹⁰⁷ is C₇-C₂₅arylalkyl, C₆-C₁₈aryl; C₆-C₁₈aryl which is substituted by C₁-C₁₈alkyl, C₁-C₁₈perfluoroalkyl, or C₁-C₁₈alkoxy; C₁-C₁₈alkyl which is interrupted by-O-, or-S-; or -COOR¹²⁴;
R¹²⁴ is C₁-C₂₅alkyl group, especially a C₄-C₂₅alkyl, which may optionally be interrupted by one or more oxygen or sulphur atoms, C₇-C₂₅arylalkyl,
R¹⁰⁸ and R¹⁰⁹ are independently of each other H, C₁-C₂₅alkyl, C₁-C₂₅alkyl which is substituted by E' and/or interrupted by D', C₇-C₂₅arylalkyl, C₆-C₂₄aryl, C₆-C₂₄aryl which is substituted by G, C₂-C₂₀heteroaryl, C₂-C₂₀heteroaryl which is substituted by G, C₂-C₁₈alkenyl, C₂-C₁₈alkynyl, C₁-C₁₈alkoxy, C₁-C₁₈alkoxy which is substituted by E' and/or interrupted by D', or C₇-C₂₅aralkyl, or
R¹⁰⁸ and R¹⁰⁹ together form a group of formula =CR¹¹⁰R¹¹¹, wherein
R¹¹⁰ and R¹¹¹ are independently of each other H, C₁-C₁₈alkyl, C₁-C₁₈alkyl which is substituted by E' and/or interrupted by D', C₆-C₂₄aryl, C₆-C₂₄aryl which is substituted by G, or C₂-C₂₀heteroaryl, or C₂-C₂₀heteroaryl which is substituted by G, or
R¹⁰⁸ and R¹⁰⁹ together form a five or six membered ring, which optionally can be substituted by C₁-C₁₈alkyl, C₁-C₁₈alkyl which is substituted by E' and/or interrupted by D', C₆-C₂₄aryl, C₆-C₂₄aryl which is substituted by G, C₂-C₂₀heteroaryl, C₂-C₂₀heteroaryl which is substituted by G, C₂-C₁₈alkenyl, C₂-C₁₈alkynyl, C₁-C₁₈alkoxy, C₁-C₁₈alkoxy which is substituted by E' and/or interrupted by D', or C₇-C₂₅aralkyl,
D' is -CO-, -COO-, -S-, -O-, or -NR¹¹²⁻,
E' is C₁-C₈thioalkoxy, C₁-C₈alkoxy, CN, -NR¹¹²R¹¹³, -CONR¹¹²R¹¹³, or halogen,
G is E', or C₁-C₁₈alkyl, and
R¹¹² and R¹¹³ are independently of each other H; C₆-C₁₈aryl; C₆-C₁₈aryl which is substituted by C₁-C₁₈alkyl, or C₁-C₁₈alkoxy; or C₁-C₁₈alkyl which is interrupted by -O- and
B, D and E are independently of each other a group of formula 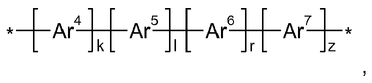 or formula **X,** with the proviso that in case B, D and E are a group of formula **X,** they are different from A, wherein
k is 1,
l is 0, or 1,
r is 0, or 1,
z is 0, or 1, and
Ar⁴, Ar⁵, Ar⁶ and Ar⁷ are independently of each other a group of formula 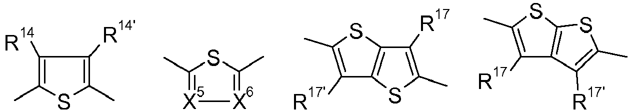 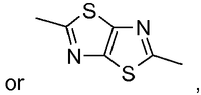 wherein one of X⁵ and X⁶ is N and the other is CR¹⁴, R¹⁴, R^{14'}, R¹⁷ and R^{17'} are independently of each other H, or a C₁-C₂₅alkyl group, especially a C₆-C₂₅alkyl, which may optionally be interrupted by one or more oxygen atoms.

5. The semiconductor device according to any of claims 1 to 4, wherein the DPP polymer is selected from polymers of formula 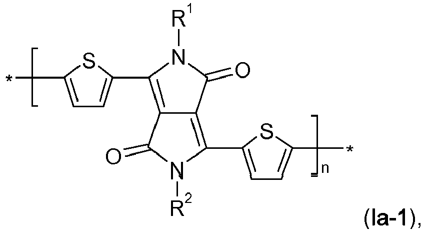 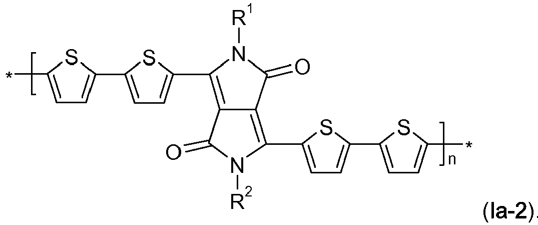 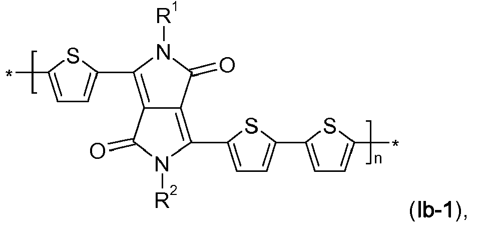 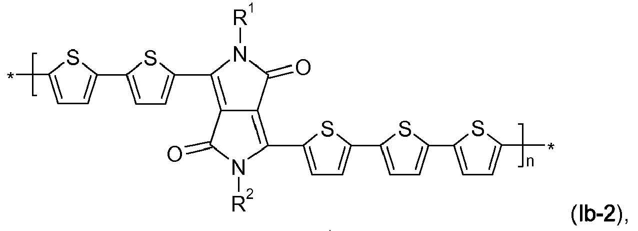 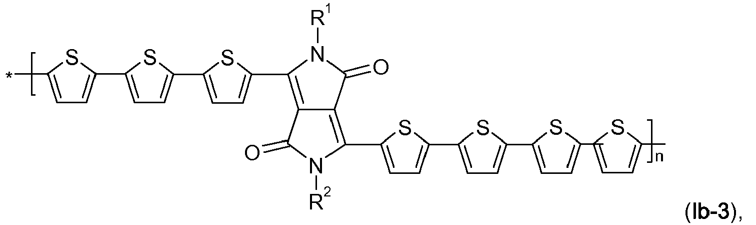 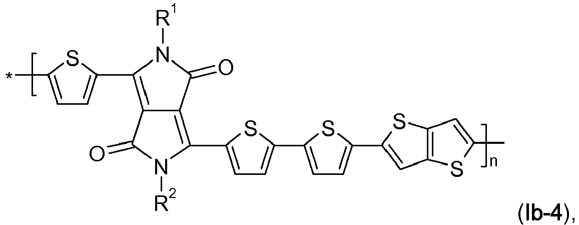 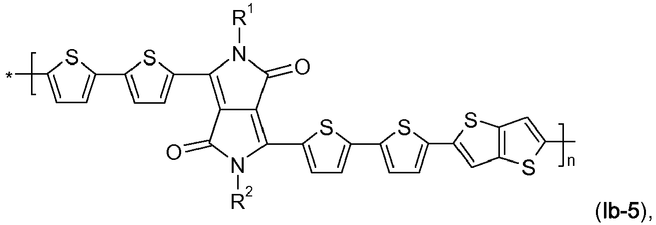 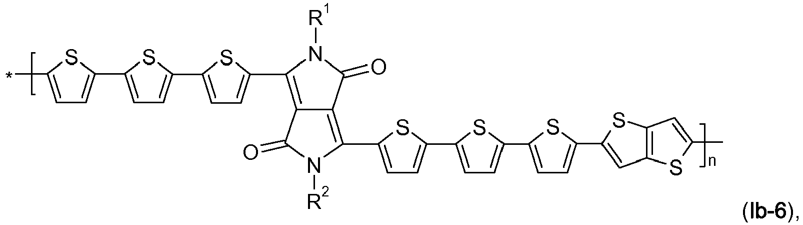 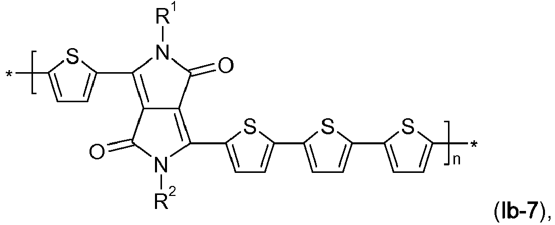 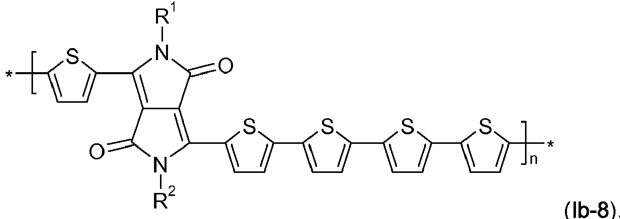 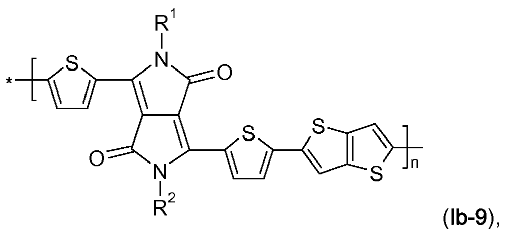 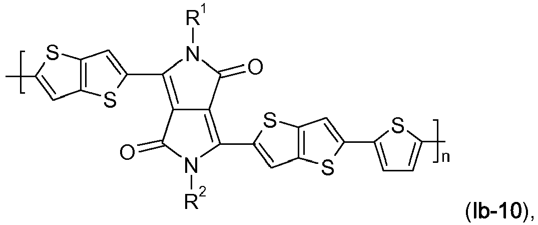 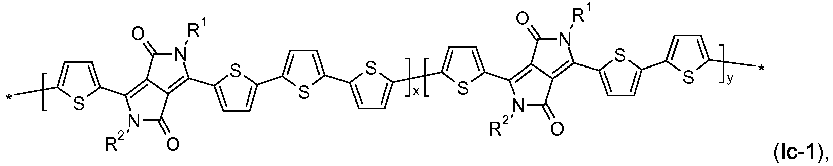 and 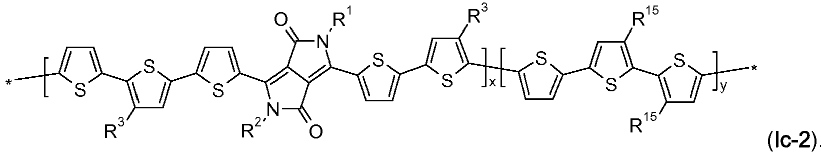
n is 4 to 1000, especially 4 to 200, very especially 5 to 100,
R¹ and R² are a C₁-C₃₆alkyl group, especially a C₈-C₃₆alkyl group,
R³ is a C₁-C₁₈alkyl group, R¹⁵ is a C₄-C₁₈alkyl group,
x = 0.995 to 0.005, y = 0.005 to 0.995, especially x = 0.4 to 0.9, y = 0.6 to 0.1, and wherein x + y = 1.

6. The semiconductor device according to any of claims 1 to 5, wherein the acceptor compound is a compound selected from quinoid compounds, such as quinone or quinone derivatives, 1,3,2-dioxaborines, 1,3,2-dioxaborine derivatives, oxocarbon-, pseudooxocarbon- and radialene compounds, and imidazole derivatives.

7. The semiconductor device according to any of claims 1 to 6, wherein the acceptor compound is a compound of formula 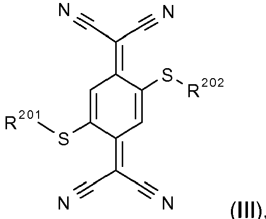 wherein R²⁰¹ and R²⁰² independently of one another are C₁-C₁₂alkyl, C₁-C₁₂alkyl, which is interrupted by one, or more oxygen atoms, C₃-C₈cycloalkyl which is unsubstituted or substituted by C₁-C₄alkyl, unsubstituted C₆-C₁₂aryl, or C₃-C₇heteroaryl, or benzyl, or C₆-C₁₂aryl, or C₃-C₇heteroaryl, or benzyl which is substituted by F, Cl, Br, C₁-C₆alkyl, C₁-C₆alkoxy, or di(C₁-C₆alkylamino); or a compound of formula 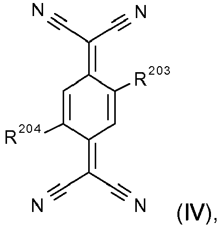 wherein R²⁰³ and R²⁰⁴ independently of one another are H, Cl, or C₁-C₂₅alkoxy.

8. The semiconductor device according to claim 7, wherein the acceptor compound is selected from

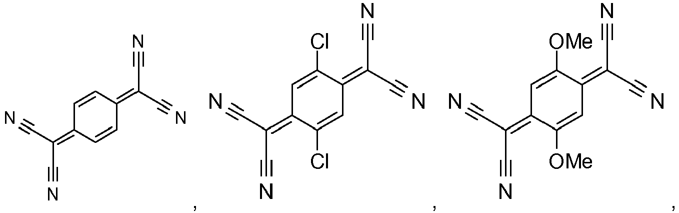

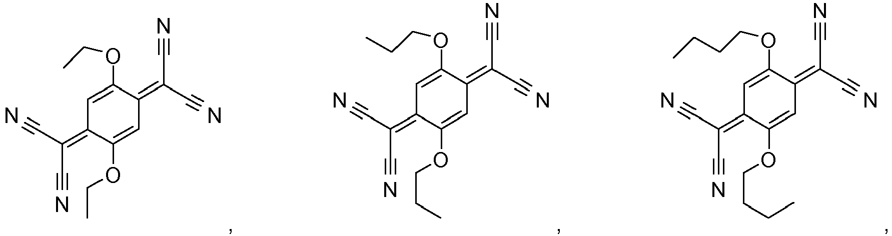

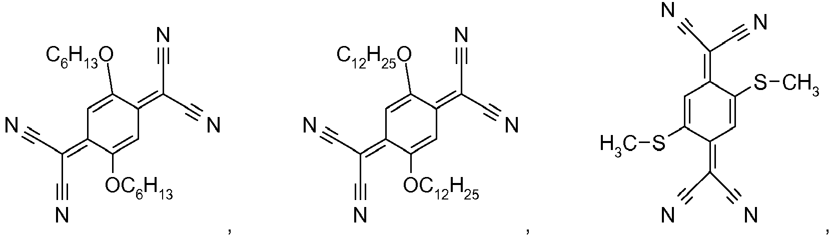

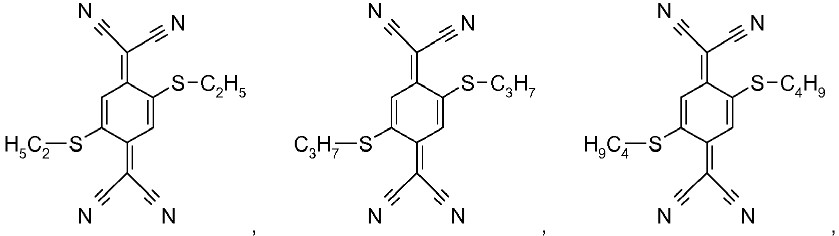

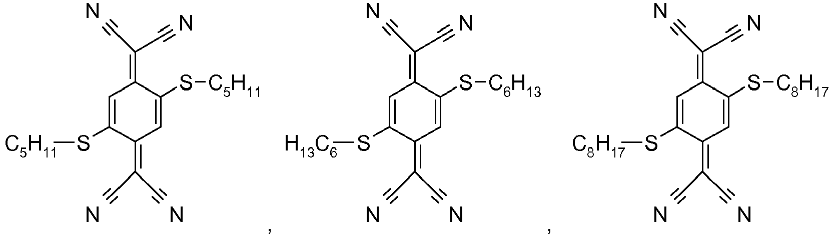

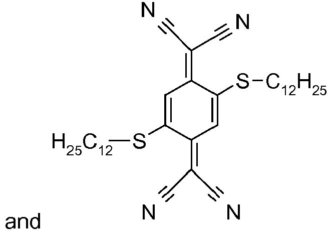

9. The semiconductor device according to 6, wherein the acceptor compound is a compound selected from 2-(6-dicyanomethylene-1,3,4,5,7,8-hexafluoro-6H-naphthalen-2-ylidene)-malononitrile, 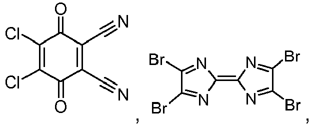 2,3,5,6-tetrafluoro-7,7,8,8-tetracyanoquinodimethane (F₄-TCNQ),

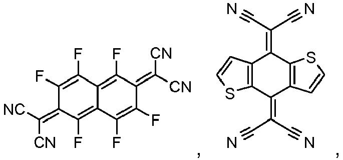

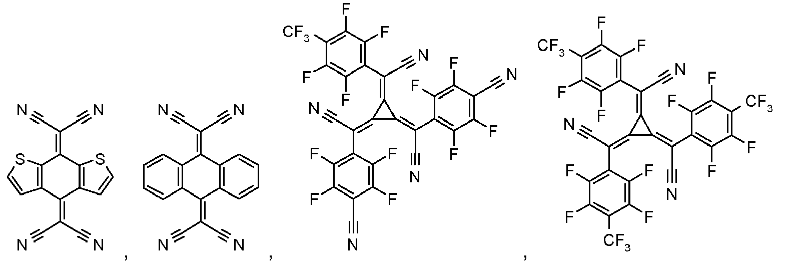

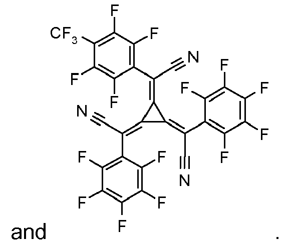

10. The semiconductor device according to claim 9, wherein the acceptor compound is 2,3,5,6-tetrafluoro-7,7,8,8-tetracyanoquinodimethane (F₄-TCNQ).

11. The semiconductor device according to claim 10, wherein the DPP polymer is represented by formula 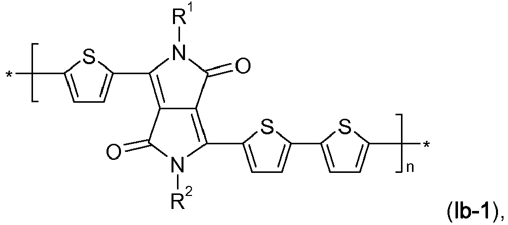 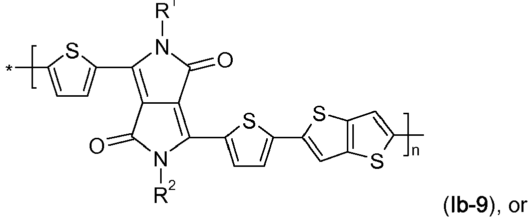 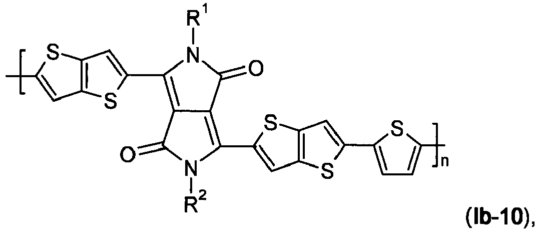 wherein n is 5 to 100 and R¹ and R² are a C₁-C₃₆alkyl group, especially a C₈-C₃₆alkyl group.

12. The semiconductor device according to any of claims 1 to 11, wherein the acceptor compound is contained in an amount of 0.5 to 5 % by weight, based on the amount of DPP polymer and acceptor compound.

13. An organic layer, especially a semiconducting layer, comprising a polymer comprising repeating units having a diketopyrrolopyrrole skeleton (DPP polymer) and an acceptor compound having an electron affinity of greater than 4.6 eV, especially greater than 4.8 eV, very especially greater than 5.0 eV, wherein the acceptor compound is contained in an amount of 0.1 to 8 % by weight, based on the amount of DPP polymer and acceptor compound.

14. Use of the organic layer according to claim 13 in an organic semiconductor device.

15. An apparatus comprising the organic semiconductor device according to any of claims 1 to 12, or the organic layer according to claim 13.

## Patentansprüche

1. Halbleitervorrichtung mit einer Schicht, die ein Wiederholungseinheiten mit einem Diketopyrrolpyrrolgerüst umfassendes Polymer (DPP-Polymer) und eine Akzeptorverbindung mit einer Elektronenaffinität (im Vakuum) von 4,6 eV oder mehr umfasst, wobei die Akzeptorverbindung in einer Menge von 0,1 bis 8 Gew.-%, bezogen auf die Menge an DPP-Polymer und Akzeptorverbindung, enthalten ist.

2. Halbleitervorrichtung nach Anspruch 1, bei der es sich um einen organischen Feldeffekttransistor handelt.

3. Halbleitervorrichtung nach Anspruch 2, wobei der organische Feldeffekttransistor eine Gate-Elektrode, eine Gate-Isolierschicht, eine Halbleiterschicht, eine Source-Elektrode und eine Drain-Elektrode umfasst, wobei die Halbleiterschicht die das DPP-Polymer und die Akzeptorverbindung umfassende Schicht darstellt.

4. Halbleitervorrichtung nach einem der Ansprüche 1 bis 3, wobei das DPP-Polymer aus Polymeren der Formel 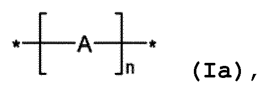 Copolymeren der Formel 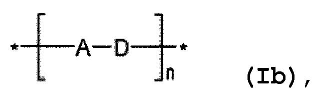 Copolymeren der Formel 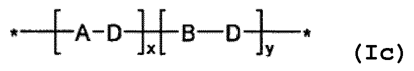 und Copolymeren der Formel 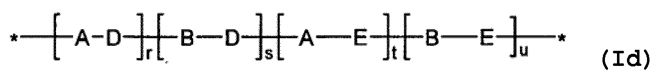 ausgewählt ist,
wobei
x = 0,995 bis 0,005, y = 0,005 bis 0,995, speziell x = 0,2 bis 0,8, y = 0,8 bis 0,2, und wobei x + y = 1;
r = 0,985 bis 0,005, s = 0,005 bis 0,985, t = 0,005 bis 0,985, u = 0,005 bis 0,985, und wobei r + s + t + u = 1;
n für 4 bis 1000, speziell 4 bis 200, ganz speziell 5 bis 100, steht,
A für eine Gruppe der Formel 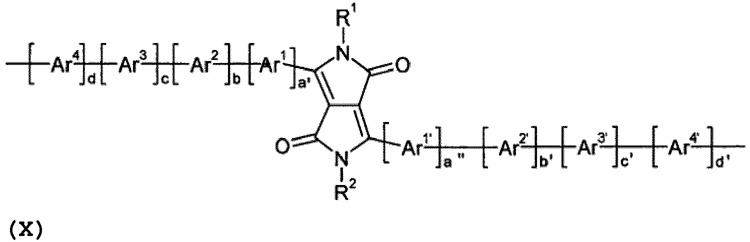
steht, wobei a' für 1, 2 oder 3 steht, a" für 0, 1, 2 oder 3 steht; b für 0, 1, 2 oder 3 steht; b' für 0, 1, 2 oder 3 steht; c für 0, 1, 2 oder 3 steht; c' für 0, 1, 2 oder 3 steht; d für 0, 1, 2 oder 3 steht; d' für 0, 1, 2 oder 3 steht; mit der Maßgabe, dass b' nicht für 0 steht, wenn a" für 0 steht;
R¹ und R² gleich oder verschieden sein können und aus Wasserstoff, einer C₁-C₁₀₀-Alkylgruppe, -COOR¹⁰⁶", einer C₁-C₁₀₀-Alkylgruppe, die durch ein oder mehrere Halogenatome, eine oder mehrere Hydroxylgruppen, eine oder mehrere Nitrogruppen, ein oder mehrere -CN oder eine oder mehrere C₆-C₁₈-Arylgruppen substituiert ist und/oder durch -0-, -COO-, -OCO- oder -S- unterbrochen ist; einer C₇-C₁₀₀-Arylalkylgruppe, einer Carbamoylgruppe, C₅-C₁₂-Cycloalkyl, das ein- bis dreifach durch C₁-C₈-Alkyl und/oder C₁-C₈-Alkoxy substituiert sein kann; einer C₆-C₂₄-Arylgruppe, insbesondere Phenyl oder 1- oder 2-Naphthyl, das ein- bis dreifach durch C₁-C₈-Alkyl, C₁-C₂₅-Thioalkoxy und/oder C₁-C₂₅-Alkoxy substituiert sein kann, oder Pentafluorphenyl, ausgewählt sind;
R^{106"} für C₁-C₅₀-Alkyl, speziell C₄-C₂₅-Alkyl, steht; Ar¹, Ar^{1'}, Ar², Ar^{2'}, Ar³, Ar^{3'}, Ar⁴ und Ar^{4'} unabhängig voneinander für heteroaromatische oder aromatische Ringe, die gegebenenfalls kondensiert und/oder substituiert sind, speziell 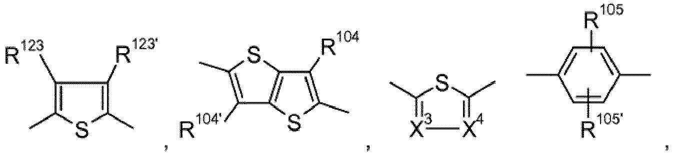 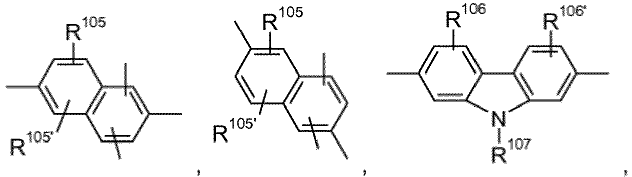 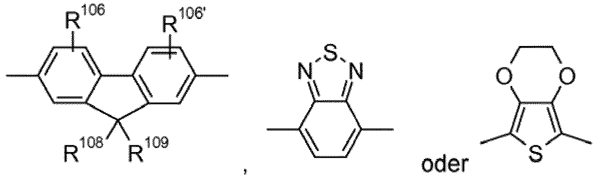 stehen, wobei
eine der Variablen X³ und X⁴ für N steht und die andere für CR⁹⁹ steht,
R⁹⁹, R¹⁰⁴, R^{104'}, R¹²³ und R^{123'} unabhängig voneinander für Wasserstoff, Halogen, speziell F, oder eine C₁-C₂₅-Alkylgruppe, speziell ein C₄-C₂₅-Alkyl, die gegebenenfalls durch ein oder mehrere Sauerstoff- oder Schwefelatome unterbrochen sein kann, C₇-C₂₅-Arylalkyl oder eine C₁-C₂₅-Alkoxygruppe stehen;
R¹⁰⁵, R^{105'} R¹⁰⁶ und R^{106'} unabhängig voneinander für Wasserstoff, Halogen, C₁-C₂₅-Alkyl, das gegebenenfalls durch ein oder mehrere Sauerstoff- oder
Schwefelatome unterbrochen sein kann, C₇-C₂₅-Arylalkyl oder C₁-C₁₈-Alkoxy stehen;
R¹⁰⁷ für C₇-C₂₅-Arylalkyl, C₆-C₁₈-Aryl; C₆-C₁₈-Aryl, das durch C₁-C₁₈-Alkyl, C₁-C₁₈-Perfluoralkyl oder C₁-C₁₈-Alkoxy substituiert ist; C₁-C₁₈-Alkyl; C₁-C₁₈-Alkyl, das durch -0- oder -S- unterbrochen ist; oder -COOR¹²⁴ steht; R¹²⁴ für eine C₁-C₂₅-Alkylgruppe, speziell ein C₄-C₂₅-Alkyl, die gegebenenfalls durch ein oder mehrere Sauerstoff- oder Schwefelatome unterbrochen ist, oder C₇-C₂₅-Arylalkyl steht,
R¹⁰⁸ und R¹⁰⁹ unabhängig voneinander für H, C₁-C₂₅-Alkyl, C₁-C₂₅-Alkyl, das durch E' substituiert und/oder durch D' unterbrochen ist, C₇-C₂₅-Arylalkyl, C₆-C₂₄-Aryl, C₆-C₂₄-Aryl, das durch G substituiert ist, C₂-C₂₀-Heteroaryl, C₂-C₂₀-Heteroaryl, das durch G substituiert ist, C₂-C₁₈-Alkenyl, C₂-C₁₈-Alkinyl, C₁-C₁₈-Alkoxy, C₁-C₁₈-Alkoxy, das durch E' substituiert und/oder durch D' unterbrochen ist, oder C₇-C₂₅-Aralkyl stehen oder
R¹⁰⁸ und R¹⁰⁹ zusammen eine Gruppe der Formel =CR¹¹⁰R¹¹¹ bilden, wobei
R¹¹⁰ und R¹¹¹ unabhängig voneinander für H, C₁-C₁₈-Alkyl, C₁-C₁₈-Alkyl, das durch E' substituiert und/oder durch D' unterbrochen ist, C₆-C₂₄-Aryl, C₆-C₂₄-Aryl, das durch G substituiert ist, oder C₂-C₂₀-Heteroaryl oder C₂-C₂₀-Heteroaryl, das durch G substituiert ist, stehen oder
R¹⁰⁸ und R¹⁰⁹ zusammen einen fünf- oder sechsgliedrigen Ring bilden, der gegebenenfalls durch C₁-C₁₈-Alkyl, C₁-C₁₈-Alkyl, das durch E' substituiert und/oder durch D' unterbrochen ist, C₆-C₂₄-Aryl, C₆-C₂₄-Aryl, das durch G substituiert ist, C₂-C₂₀-Heteroaryl, C₂-C₂₀-Heteroaryl, das durch G substituiert ist, C₂-C₁₈-Alkenyl, C₂-C₁₈-Alkinyl, C₁-C₁₈-Alkoxy, C₁-C₁₈-Alkoxy, das durch E' substituiert und/oder durch D' unterbrochen ist, oder C₇-C₂₅-Aralkyl substituiert sein kann, D' für -CO-, -COO-, -S-, -O- oder -NR¹¹²- steht,
E' für C₁-C₈-Thioalkoxy, C₁-C₈-Alkoxy, CN, -NR¹¹²R¹¹³, -CONR¹¹²R¹¹³ oder Halogen steht,
G für E' oder C₁-C₁₈-Alkyl steht und
R¹¹² und R¹¹³ unabhängig voneinander für H; C₆-C₁₈-Aryl; C₆-C₁₈-Aryl, das durch C₁-C₁₈-Alkyl oder C₁-C₁₈-Alkoxy substituiert ist; C₁-C₁₈-Alkyl oder C₁-C₁₈-Alkyl, das durch -O- unterbrochen ist, stehen und
B, D und E unabhängig voneinander für eine Gruppe der Formel 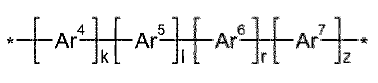 oder Formel X stehen, mit der Maßgabe, dass B, D und E dann, wenn sie für eine Gruppe der Formel X stehen, von A verschieden sind, wobei
k für 1 steht,
1 für 0 oder 1 steht,
r für 0 oder 1 steht,
z für 0 oder 1 steht und
Ar⁴, Ar⁵, Ar⁶ und Ar⁷ unabhängig voneinander für eine Gruppe der Formel 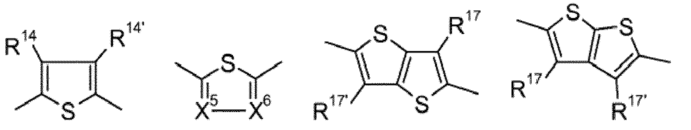 oder 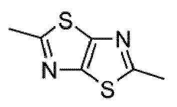 stehen, wobei eine der Variablen X⁵ und X⁶ für N steht und die andere für CR¹⁴ steht, R¹⁴, R^{14'} , R¹⁷ und R^{17'} unabhängig voneinander für H oder eine C₁-C₂₅-Alkylgruppe, speziell ein C₆-C₂₅-Alkyl, die gegebenenfalls durch ein oder mehrere Sauerstoffatome unterbrochen ist, stehen.

5. Halbleitervorrichtung nach einem der Ansprüche 1 bis 4, wobei das DPP-Polymer aus Polymeren der Formel 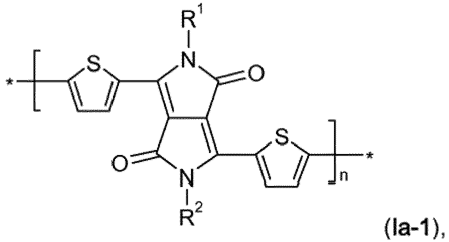 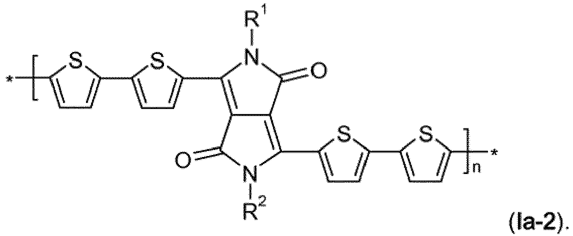 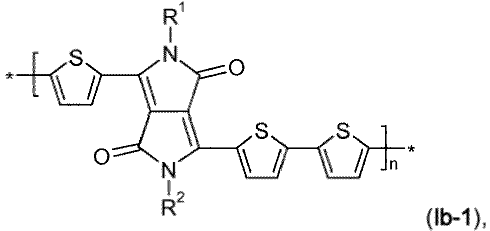 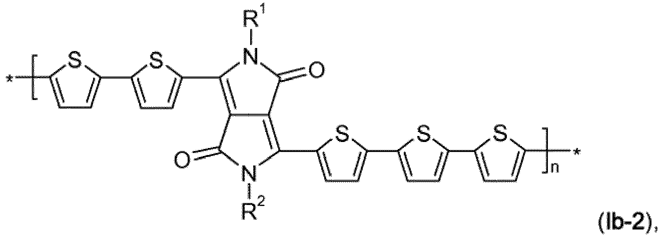 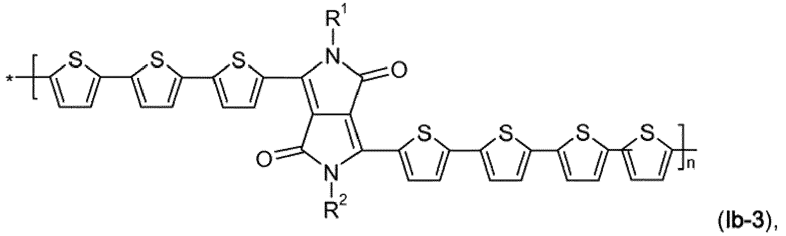 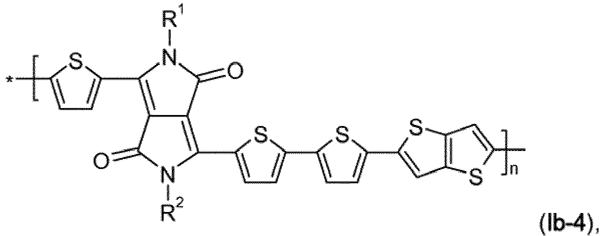 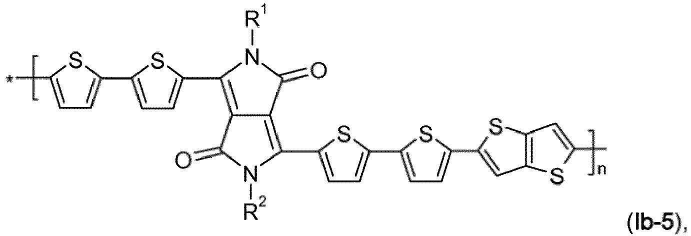 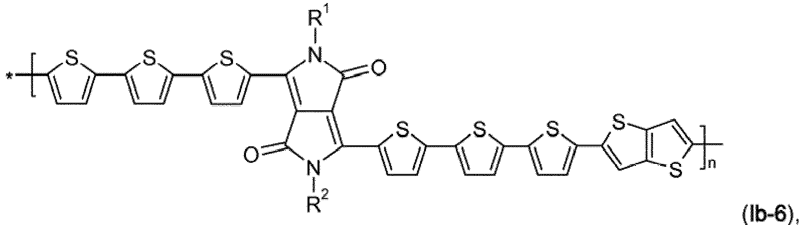 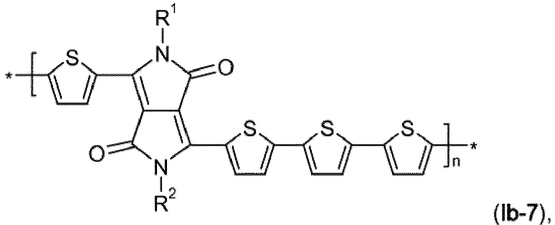 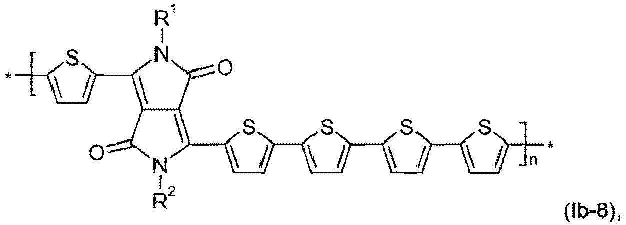 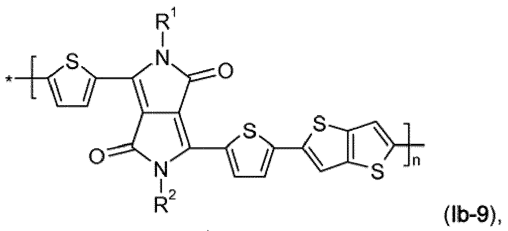 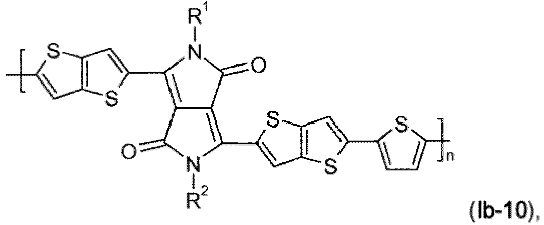 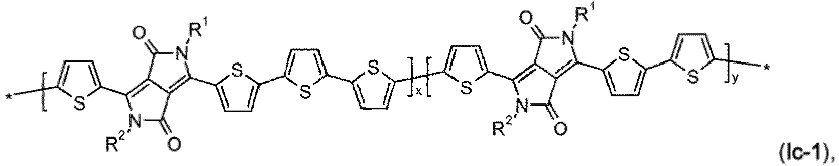 und 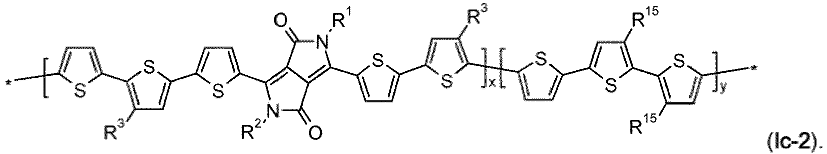 ausgewählt ist, wobei
n für 4 bis 1000, speziell 4 bis 200, ganz speziell 5 bis 100, steht,
R¹ und R² für eine C₁-C₃₆-Alkylgruppe, speziell eine C₈-C₃₆-Alkylgruppe, stehen,
R³ für eine C₁-C₁₈-Alkylgruppe steht, R¹⁵ für eine C₄-C₁₈-Alkylgruppe steht,
x = 0,995 bis 0,005, y = 0,005 bis 0,995, speziell x = 0,4 bis 0,9, y = 0,6 bis 0,1, und wobei x + y = 1.

6. Halbleitervorrichtung nach einem der Ansprüche 1 bis 5, wobei es sich bei der Akzeptorverbindung um eine Verbindung handelt, die aus chinoiden Verbindungen, wie Chinon oder Chinonderivaten, 1,3,2-Dioxaborinen, 1,3,2-Dioxaborinderivaten, Oxokohlenstoff-, Pseudooxokohlenstoff- und Radialenverbindungen und Imidazolderivaten ausgewählt ist.

7. Halbleitervorrichtung nach einem der Ansprüche 1 bis 6, wobei es sich bei der Akzeptorverbindung um eine Verbindung der Formel 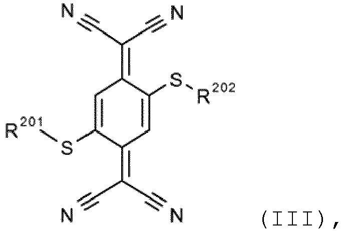 wobei
R²⁰¹ und R²⁰² unabhängig voneinander für C₁-C₁₂-Alkyl, C₁-C₁₂-Alkyl, das durch ein oder mehrere Sauerstoffatome unterbrochen ist, C₃-C₈-Cycloalkyl, das unsubstituiert oder durch C₁-C₄-Alkyl substituiert ist, unsubstituiertes C₆-C₁₂-Aryl oder C₃-C₇-Heteroaryl oder Benzyl oder C₆-C₁₂-Aryl oder C₃-C₇-Heteroaryl oder Benzyl, das durch F, Cl, Br, C₁-C₆-Alkyl, C₁-C₆-Alkoxy oder Di(C₁-C₆-alkylamino) unterbrochen ist, stehen; oder eine Verbindung der Formel 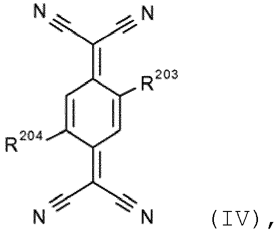 wobei R²⁰³ und R²⁰⁴ unabhängig voneinander für H, Cl oder C₁-C₂₅-Alkoxy stehen, handelt.

8. Halbleitervorrichtung nach Anspruch 7, wobei die Akzeptorverbindung aus 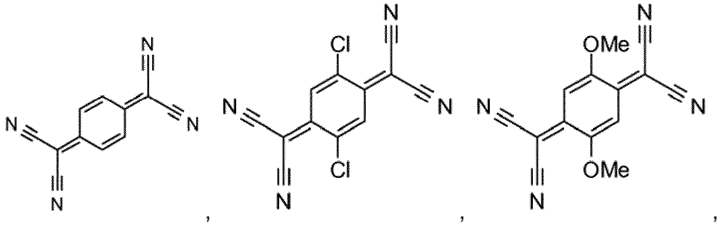 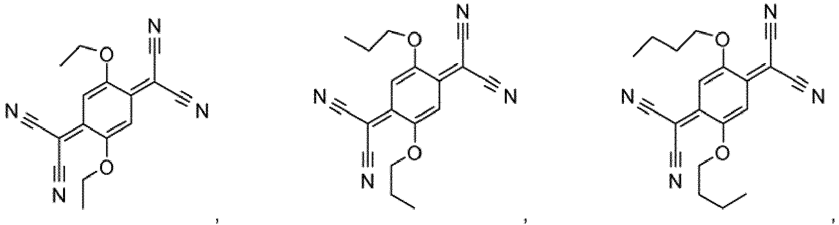 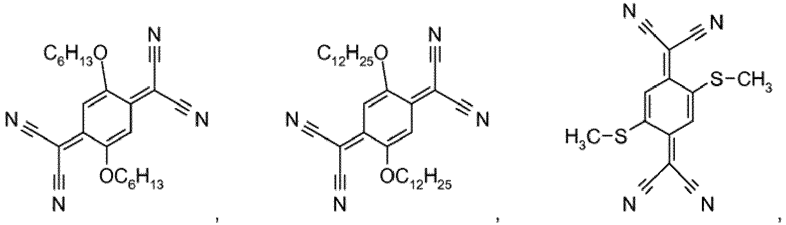 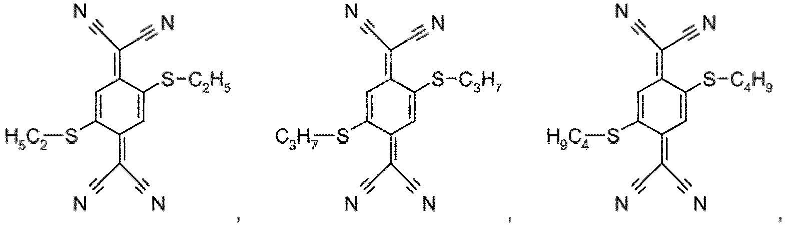 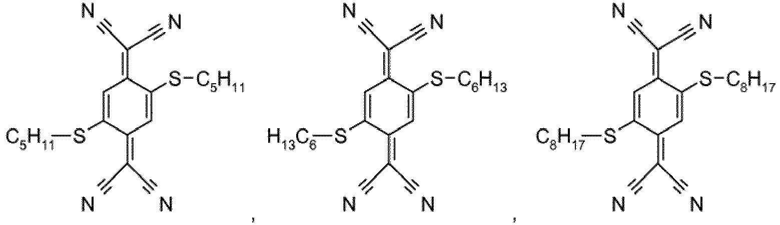 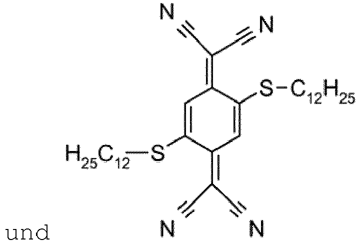 ausgewählt ist.

9. Halbleitervorrichtung nach Anspruch 6, wobei es sich bei der Akzeptorverbindung um eine Verbindung handelt, die aus 2-(6-Dicyanomethylen-1,3,4,5,7,8-hexafluor-6H-naphthalin-2-yliden-(malononitril), 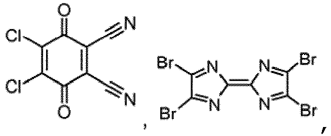 2,3,5,6-Tetrafluor-7,7,8,8-tetracyanochinodimethan (F₄-TCNQ), 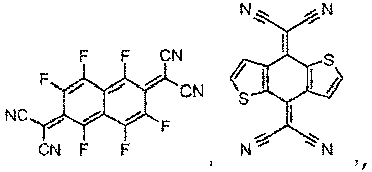 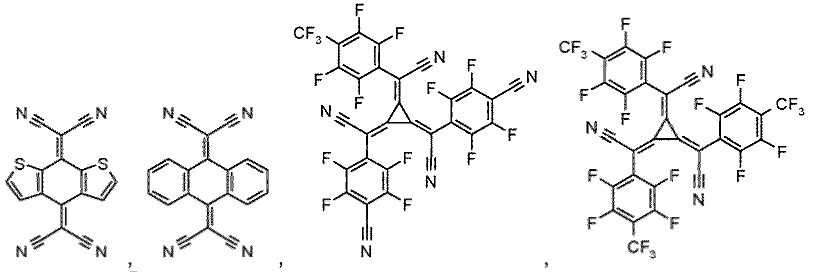 und 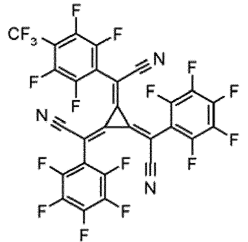 ausgewählt ist.

10. Halbleitervorrichtung nach Anspruch 9, wobei es sich bei der Akzeptorverbindung um 2,3,5,6-Tetrafluor-7,7,8,8-tetracyanochinodimethan (F₄-TCNQ) handelt.

11. Halbleitervorrichtung nach Anspruch 10, wobei das DPP-Polymer durch Formel 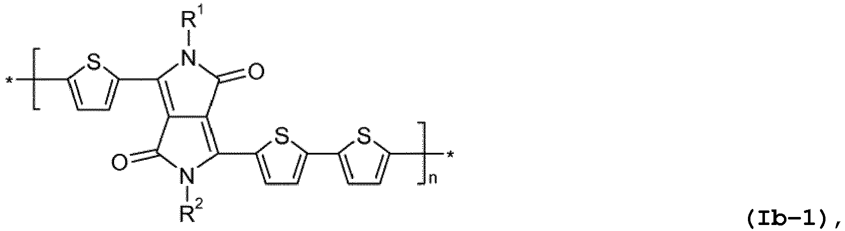 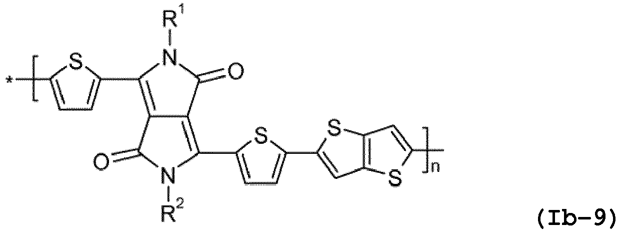 oder 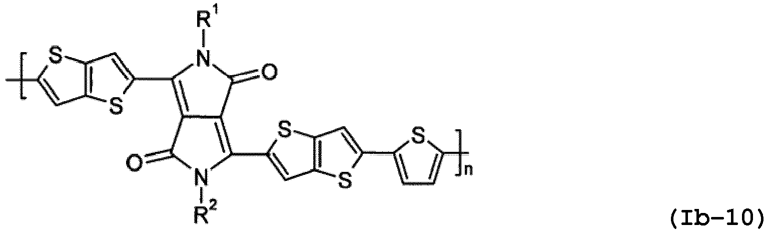 wiedergegeben wird, wobei n für 5 bis 100 steht und R¹ und R² für eine C₁-C₃₆-Alkylgruppe, speziell eine C₈-C₃₆-Alkylgruppe, stehen.

12. Halbleitervorrichtung nach einem der Ansprüche 1 bis 11, wobei die Akzeptorverbindung in einer Menge von 0,5 bis 5 Gew.-%, bezogen auf die Menge an DPP-Polymer und Akzeptorverbindung, enthalten ist.

13. Organische Schicht, speziell halbleitende Schicht, die ein Wiederholungseinheiten mit einem Diketopyrrolpyrrolgerüst umfassendes Polymer (DPP-Polymer) und eine Akzeptorverbindung mit einer Elektronenaffinität von mehr als 4,6 eV, speziell mehr als 4,8 eV, ganz speziell mehr als 5,0 eV, umfasst, wobei die Akzeptorverbindung in einer Menge von 0,1 bis 8 Gew.-%, bezogen auf die Menge an DPP-Polymer und Akzeptorverbindung, enthalten ist.

14. Verwendung der organischen Schicht nach Anspruch 13 in einer organischen Halbleitervorrichtung.

15. Apparatur, umfassend die organische Halbleitervorrichtung nach einem der Ansprüche 1 bis 12 oder die organische Schicht nach Anspruch 13.

## Revendications

1. Dispositif à semi-conducteur, comprenant une couche comprenant un polymère comprenant des motifs de répétition ayant un squelette de dicétopyrrolopyrrole (polymère DPP) et un composé accepteur ayant une affinité électronique (sous vide) de 4,6 eV, ou plus, dans lequel le composé accepteur est contenu en une quantité de 0,1 à 8 % en poids, sur la base de la quantité de polymère DPP et de composé accepteur.

2. Dispositif à semi-conducteur selon la revendication 1, qui est un transistor à effet de champ organique.

3. Dispositif à semi-conducteur selon la revendication 2, dans lequel le transistor à effet de champ organique comprend une électrode de grille, une couche isolante de grille, une couche de semi-conducteur, une électrode de source, et une électrode de drain, la couche de semi-conducteur représente la couche comprenant le polymère DPP et le composé accepteur.

4. Dispositif à semi-conducteur selon l'une quelconque des revendications 1 à 3, dans lequel le polymère DPP est choisi parmi des polymères de formule 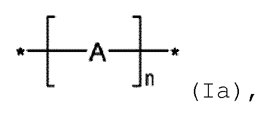 des copolymères de formule 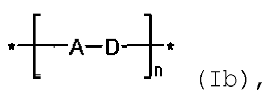 des copolymères de formule 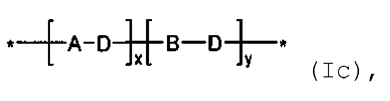 des copolymères de formule 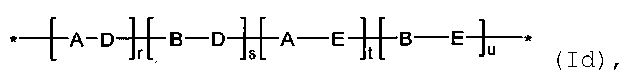 où
x = 0,995 à 0,005, y = 0,005 à 0,995, en particulier x = 0,2 à 0,8, y = 0,8 à 0,2, et où x + y = 1 ;
r = 0,985 à 0,005, s = 0,005 à 0,985, t = 0,005 à 0,985, u = 0,005 à 0,985, et où r + s + t+ u = 1 ;
n est 4 à 1000, en particulier 4 à 200, très particulièrement 5 à 100,
A est un groupe de formule 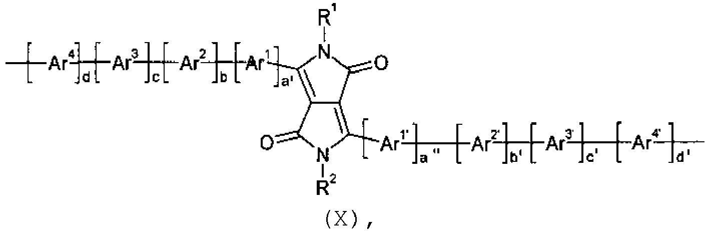
dans laquelle a' est 1, 2 ou 3, a" est 0, 1, 2 ou 3 ; b est 0, 1, 2 ou 3 ; b' est 0, 1, 2 ou 3 ; c est 0, 1, 2 ou 3 ; c' est 0, 1, 2 ou 3 ; d est 0, 1, 2 ou 3 ; d' est 0, 1, 2 ou 3 ; à condition que b' ne soit pas 0, si a" est 0 ;
R¹ et R² peuvent être identiques ou différents et sont choisis parmi hydrogène, un groupe alkyle en C₁-C₁₀₀, -COOR^{106"}, un groupe alkyle en C₁-C₁₀₀ qui est substitué par un ou plusieurs atomes d'halogène, groupes hydroxyle, groupes nitro, -CN, ou aryle en C₆-C₁₈ et/ou interrompu par -O-, -COO-, -OCO-, ou -S- ; un groupe arylalkyle en C₇-C₁₀₀, un groupe carbamoyle, un cycloalkyle en C₅-C₁₂, qui peut être substitué une à trois fois par alkyle en C₁-C₈ et/ou alcoxy en C₁-C₈, un groupe aryle en C₆-C₂₄, en particulier phényle ou 1- ou 2-naphtyle qui peut être substitué une à trois fois par alkyle en C₁-C₈, thioalcoxy en C₁-C₂₅, et/ou alcoxy en C₁-C₂₅, ou pentafluorophényle,
R^{106"} est alkyle en C₁-C₅₀, en particulier alkyle en C₄-C₂₅ ;
Ar¹, Ar^{1'}, Ar², Ar^{2'}, Ar³, Ar^{3'}, Ar⁴ et Ar^{4'} sont, indépendamment les uns des autres, des cycles hétéroaromatiques ou aromatiques, qui peuvent facultativement être condensés et/ou substitués, en particulier 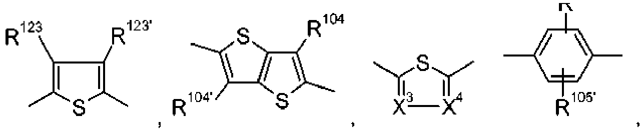 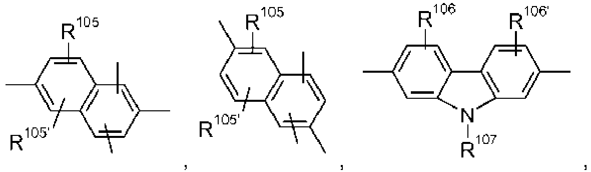 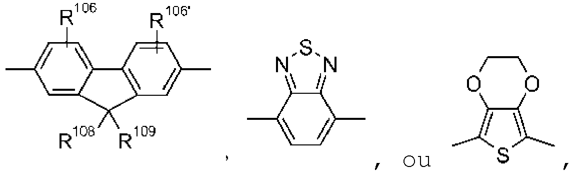 où l'un de X³ et X⁴ est N et l'autre est CR⁹⁹,
R⁹⁹, R¹⁰⁴, R^{104'}, R¹²³ et R^{123'} sont, indépendamment les uns des autres, hydrogène, halogène, en particulier F, ou un groupe alkyle en C₁-C₂₅, en particulier un alkyle en C₄-C₂₅, qui peut facultativement être interrompu par un ou plusieurs atomes d'oxygène ou de soufre, arylalkyle en C₇-C₂₅, ou un groupe alcoxy en C₁-C₂₅,
R¹⁰⁵, R^{105'}, R¹⁰⁶ et R^{106'} sont, indépendamment les uns des autres, hydrogène, halogène, alkyle en C₁-C₂₅, qui peuvent facultativement être interrompus par un ou plusieurs atomes d'oxygène ou de soufre ; arylalkyle en C₇-C₂₅, ou alcoxy en C₁-C₁₈,
R¹⁰⁷ est arylalkyle en C₇-C₂₅, aryle en C₆-C₁₈ ; aryle en C₆-C₁₈ qui est substitué par alkyle en C₁-C₁₈, perfluoroalkyle en C₁-C₁₈, ou alcoxy en C₁-C₁₈ ; alkyle en C₁-C₁₈ ; alkyle en C₁-C₁₈ qui est interrompu par -0-, ou-S- ; ou -COOR¹²⁴ ;
R¹²⁴ est un groupe alkyle en C₁-C₂₅, en particulier un alkyle en C₄-C₂₅, qui peut facultativement être interrompu par un ou plusieurs atomes d'oxygène ou de soufre, arylalkyle en C₇-C₂₅,
R¹⁰⁸ et R¹⁰⁹ sont, indépendamment l'un de l'autre, H, alkyle en C₁-C₂₅, alkyle en C₁-C₂₅ qui est substitué par E' et/ou interrompu par D', arylalkyle en C₇-C₂₅, aryle en C₆-C₂₄, aryle en C₆-C₂₄ qui est substitué par G, hétéroaryle en C₂-C₂₀, hétéroaryle en C₂-C₂₀ qui est substitué par G, alcényle en C₂-C₁₈, alcynyle en C₂-C₁₈, alcoxy en C₁-C₁₈, alcoxy en C₁-C₁₈ qui est substitué par E' et/ou interrompu par D', ou aralkyle en C₇-C₂₅, ou R¹⁰⁸ et R¹⁰⁹ forment conjointement un groupe de formule =CR¹¹⁰R¹¹¹, dans lequel
R¹¹⁰ et R¹¹¹ sont, indépendamment l'un de l'autre, H, alkyle en C₁-C₁₈, alkyle en C₁-C₁₈ qui est substitué par E' et/ou interrompu par D', aryle en C₆-C₂₄, aryle en C₆-C₂₄ qui est substitué par G, ou hétéroaryle en C₂-C₂₀, ou hétéroaryle en C₂-C₂₀ qui est substitué par G, ou R¹⁰⁸ et R¹⁰⁹ forment conjointement un cycle de cinq ou six chaînons, qui peut facultativement être substitué par alkyle en C₁-C₁₈, alkyle en C₁-C₁₈ qui est substitué par E' et/ou interrompu par D', aryle en C₆-C₂₄, aryle en C₆-C₂₄ qui est substitué par G, hétéroaryle en C₂-C₂₀, hétéroaryle en C₂-C₂₀ qui est substitué par G, alcényle en C₂-C₁₈, alcynyle en C₂-C₁₈, alcoxy en C₁-C₁₈, alcoxy en C₁-C₁₈ qui est substitué par E' et/ou interrompu par D', ou aralkyle en C₇-C₂₅, D' est -CO-, -COO-, -S-, -O-, ou -NR¹¹²-,
E' est thioalcoxy en C₁-C₈, alcoxy en C₁-C₈, CN, -NR¹¹²R¹¹³, -CONR¹¹²R¹¹³ ou halogène,
G est E', ou alkyle en C₁-C₁₈, et
R¹¹² et R¹¹³ sont, indépendamment l'un de l'autre, H ; aryle en C₆-C₁₈ ; aryle en C₆-C₁₈ qui est substitué par alkyle en C₁-C₁₈, ou alcoxy en C₁-C₁₈ ; alkyle en C₁-C₁₈ ; ou alkyle en C₁-C₁₈ qui est interrompu par -0- et
B, D et E sont, indépendamment les uns des autres, un groupe de formule 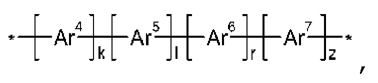 ou de formule X, à condition que, dans le cas où B, D et E sont un groupe de formule X, ils soient différents de A, où
k est 1,
1 est 0, ou 1,
r est 0, ou 1,
z est 0, ou 1, et
Ar⁴, Ar⁵, Ar⁶ et Ar⁷ sont, indépendamment les uns des autres, un groupe de formule 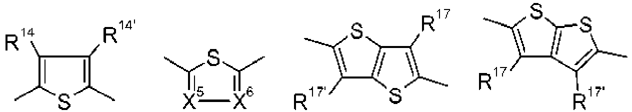 ou 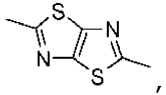 où l'un de X⁵ et X⁶ est N et l'autre est CR¹⁴,
R¹⁴, R^{14'} , R¹⁷ et R^{17'} sont, indépendamment les uns des autres, H, ou un groupe alkyle en C₁-C₂₅, en particulier un alkyle en C₆-C₂₅, qui peut facultativement être interrompu par un ou plusieurs atomes d'oxygène.

5. Dispositif à semi-conducteur selon l'une quelconque des revendications 1 à 4, dans lequel le polymère DPP est choisi parmi des polymères de formule 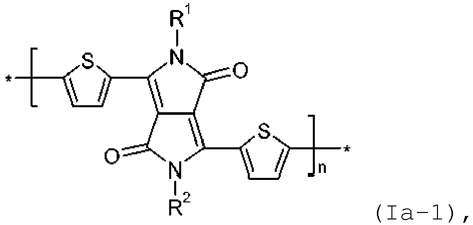 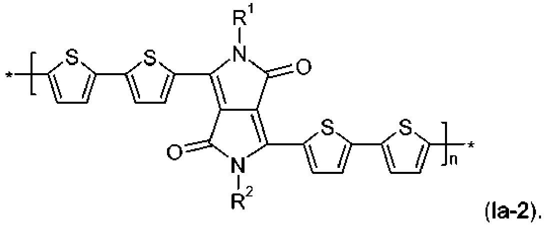 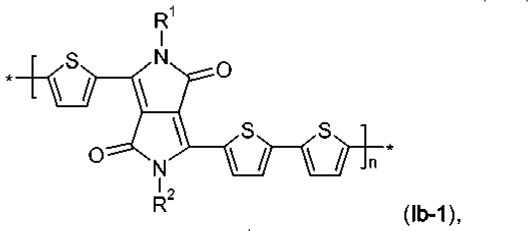 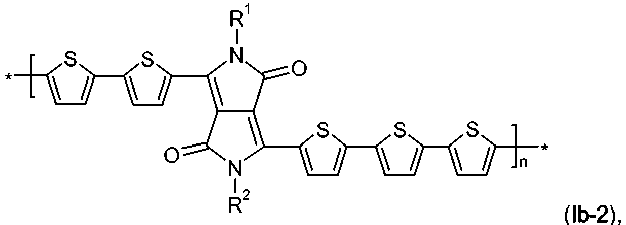 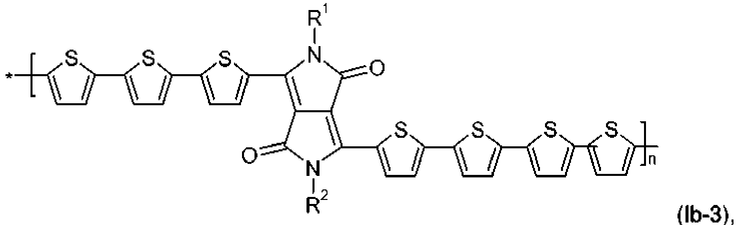 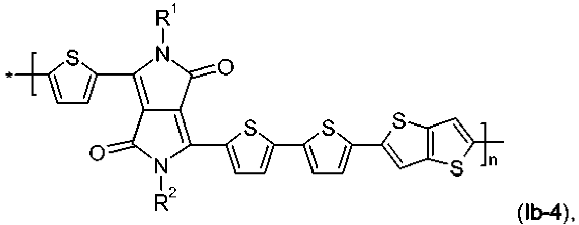 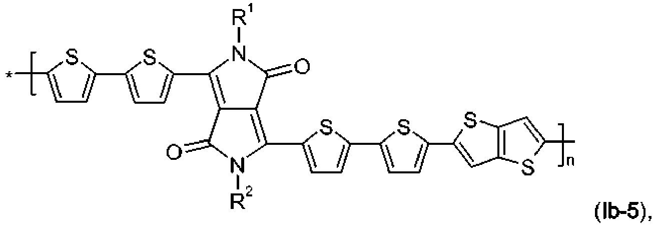 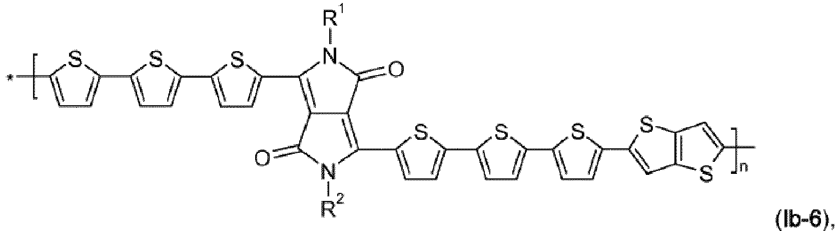 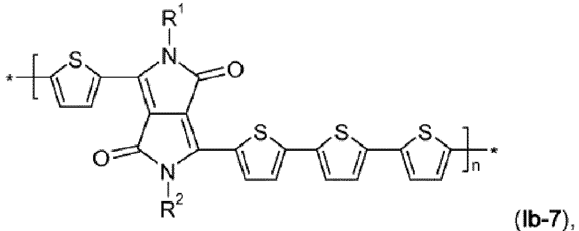 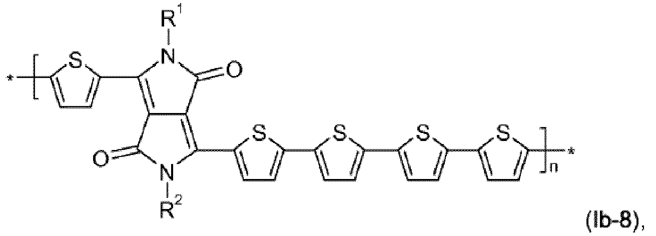 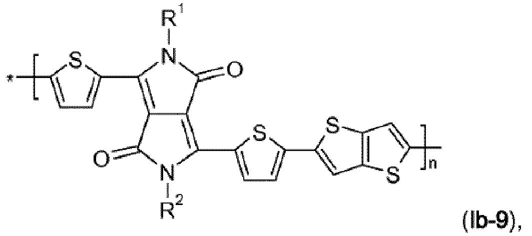 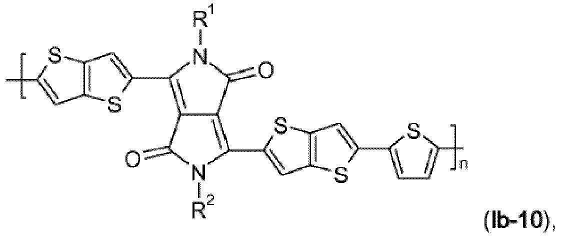 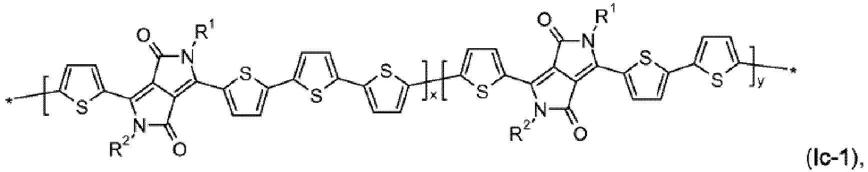 et 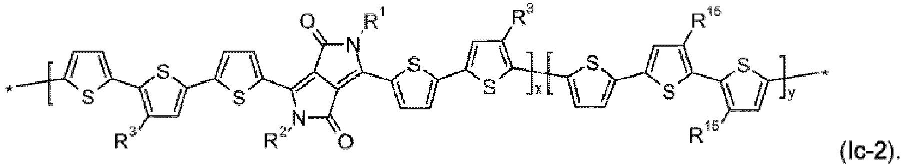
n est 4 à 1000, en particulier 4 à 200, tout particulièrement 5 à 100,
R¹ et R² sont un groupe alkyle en C₁-C₃₆, en particulier un groupe alkyle en C₈-C₃₆,
R³ est un groupe alkyle en C₁-C₁₈, R¹⁵ est un groupe alkyle en C₄-C₁₈,
x = 0,995 à 0,005, y = 0,005 à 0,995, en particulier x = 0,4 à 0,9, y = 0,6 à 0,1, et où x + y = 1.

6. Dispositif à semi-conducteur selon l'une quelconque des revendications 1 à 5, dans lequel le composé accepteur est un composé choisi parmi des composés quinoïdes, tels que la quinone ou des dérivés de quinone, des 1,3,2-dioxaborines, des dérivés de 1,3,2-dioxaborine, des composés oxocarbones, pseudooxocarbones et radialènes, et des dérivés d'imidazole.

7. Dispositif à semi-conducteur selon l'une quelconque des revendications 1 à 6, dans lequel le composé accepteur est un composé de formule 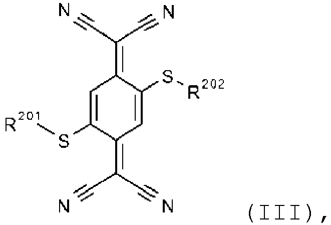 dans lequel R²⁰¹ et R²⁰², indépendamment l'un de l'autre, sont alkyle en C₁-C₁₂, alkyle en C₁-C₁₂ qui est interrompu par un ou plusieurs atomes d'oxygène, cycloalkyle en C₃-C₈ qui est non substitué ou substitué par alkyle en C₁-C₄, aryle en C₆-C₁₂ non substitué, ou hétéroaryle en C₃-C₇, ou benzyle, ou aryle en C₆-C₁₂, ou hétéroaryle en C₃-C₇, ou benzyle qui est substitué par F, Cl, Br, alkyle en C₁-C₆, alcoxy en C₁-C₆, ou di (alkyle en C₁-C₆) amino ; ou un composé de formule 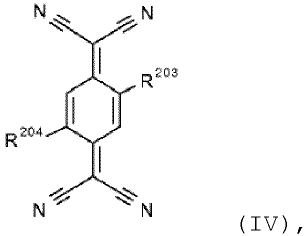 dans lequel R²⁰³ et R²⁰⁴, indépendamment l'un de l'autre, sont H, Cl, ou alcoxy en C₁-C₂₅.

8. Dispositif à semi-conducteur selon la revendication 7, dans lequel le composé accepteur est choisi parmi

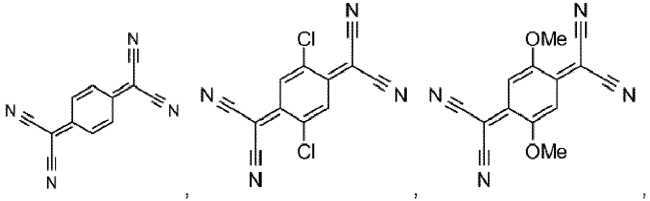

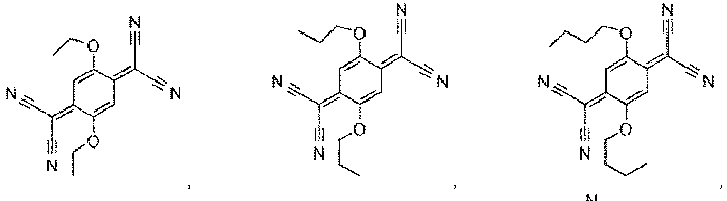

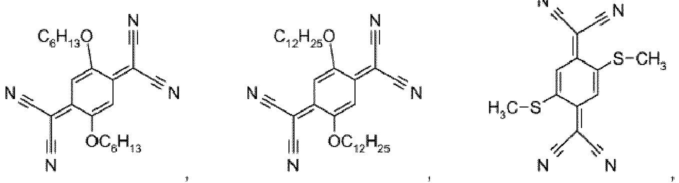

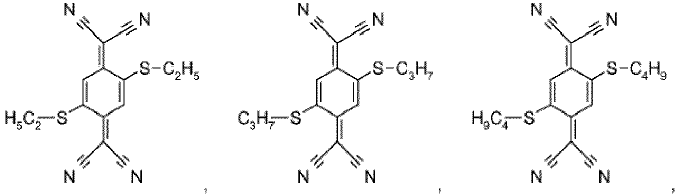

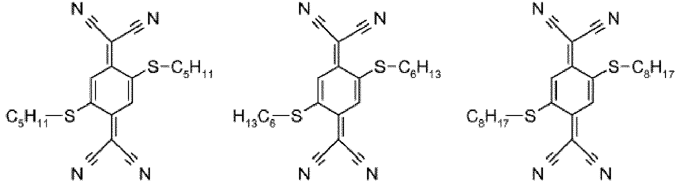

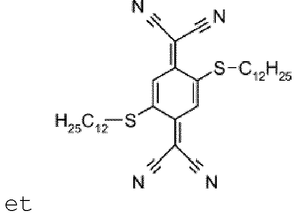

9. Dispositif à semi-conducteur selon 6, dans lequel le composé accepteur est un composé choisi parmi 2-(6-dicyanométhylène-1,3,4,5,7,8-hexafluoro-6H-naphtalén-2-ylidène)-malonitrile, 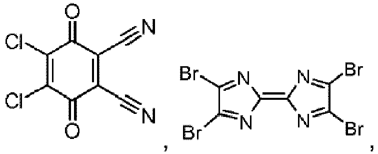 2,3,5,6-tétrafluoro-7,7,8,8-tétracyanoquinodiméthane (F₄-TCNQ),

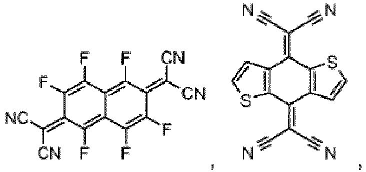

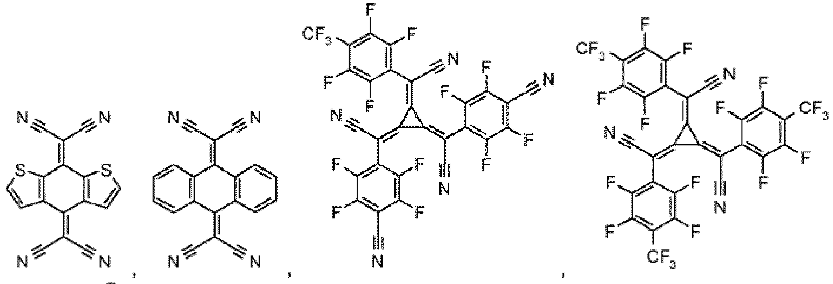

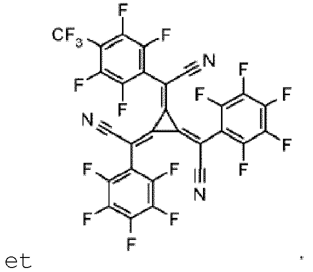

10. Dispositif à semi-conducteur selon la revendication 9, dans lequel le composé accepteur est le 2,3,5,6-tétrafluoro-7,7,8,8-tétracyanoquinodiméthane (F4-TCNQ).

11. Dispositif à semi-conducteur selon la revendication 10, dans lequel le polymère DPP est représenté par la formule 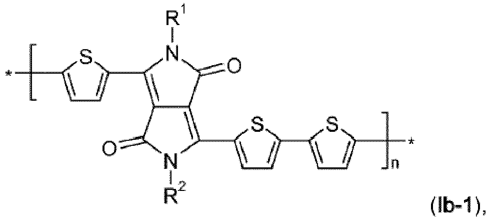 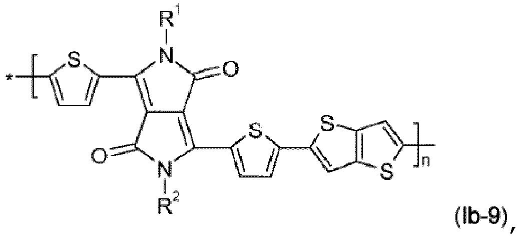 ou 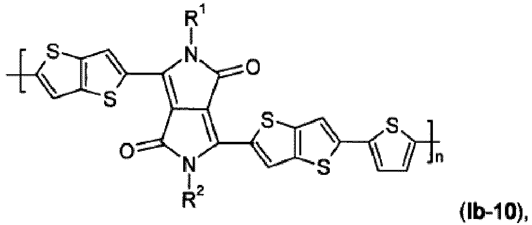 où n est 5 à 100 et R¹ et R² sont un groupe alkyle en C₁-C₃₆, en particulier un groupe alkyle en C₈-C₃₆.

12. Dispositif à semi-conducteur selon l'une quelconque des revendications 1 à 11, dans lequel le composé accepteur est contenu en une quantité de 0,5 à 5 % en poids, sur la base de la quantité de polymère DPP et de composé accepteur.

13. Couche organique, en particulier une couche semi-conductrice, comprenant un polymère comprenant des motifs de répétition ayant un squelette dicétopyrrolopyrrole (polymère DPP) et un composé accepteur ayant une affinité électronique supérieure à 4,6 eV, en particulier supérieure à 4,8 eV, tout particulièrement supérieure à 5,0 eV, dans laquelle le composé accepteur est contenu en une quantité de 0,1 à 8 % en poids, sur la base de la quantité de polymère DPP et de composé accepteur.

14. Utilisation de la couche organique selon la revendication 13 dans un dispositif à semi-conducteur organique.

15. Appareil comprenant le dispositif à semi-conducteur organique selon l'une quelconque des revendications 1 à 12, ou la couche organique selon la revendication 13.
